# EUROPÄISCHE PATENTSCHRIFT

(11) **EP 3 497 712 B1**
(45) Veröffentlichungstag und Bekanntmachung des Hinweises auf die Patenterteilung: **29.04.2020**
(21) Anmeldenummer: 16759690.7
(22) Anmeldetag: 12.08.2016
(51) Int. Cl.: H01L 21/18, H01L 21/20

(54) **VERFAHREN UND PROBENHALTER ZUM GESTEUERTEN BONDEN VON SUBSTRATEN**
METHOD AND SAMPLE HOLDER FOR THE CONTROLLED BONDING OF SUBSTRATES
PROCÉDÉ ET PORTE-ÉCHANTILLON POUR LIER DES SUBSTRATS DE FAÇON COMMANDÉE

(43) Veröffentlichungstag der Anmeldung: 19.06.2019
(73) Patentinhaber: EV Group E. Thallner GmbH, 4782 St. Florian am Inn (AT)
(72) Erfinder: ZINNER, Dominik, 4755 Zell an der Pram (AT); WAGENLEITNER, Thomas, 4971 Aurolzmünster (AT); SÜSS, Jürgen Markus, 4791 Rainbach (AT); MALLINGER, Jürgen, 4973 Senftenbach (AT); PLACH, Dr. Thomas, 4651 Stadl-Paura (AT)
(74) Vertreter: Schneider, Sascha
(86) Internationale Anmeldenummer: PCT/EP2016/069307
(87) Internationale Veröffentlichungsnummer: WO 2018/028801

(56) Entgegenhaltungen:
- WO-A1-2014/191033
- WO-A1-2016/093284
- US-A- 4 752 180
- US-B1- 7 682 933

## Beschreibung

Die vorliegende Erfindung betrifft ein Verfahren zum Bonden eines ersten Substrats mit einem zweiten Substrat sowie eine korrespondierende Vorrichtung gemäß den nebengeordneten Patentansprüchen.

Seit mehreren Jahren werden in der Halbleiterindustrie Substrate durch sogenannte Bondprozesse miteinander verbunden. Vor der Verbindung müssen diese Substrate möglichst genau zueinander ausgerichtet werden, wobei mittlerweile Abweichungen im Nanometerbereich eine Rolle spielen. Die Ausrichtung der Substrate erfolgt dabei meistens über Ausrichtungsmarken. Neben den Ausrichtungsmarken befinden sich noch andere, insbesondere funktionale Elemente, auf den Substraten, die während des Bondprozesses ebenfalls zueinander ausgerichtet sein müssen. Diese Ausrichtungsgenauigkeit zwischen den einzelnen funktionalen Elementen wird für die gesamte Substratoberfläche verlangt. Es ist daher beispielsweise nicht auseichend, wenn die Ausrichtungsgenauigkeit im Zentrum der Substrate sehr gut ist, zum Rand hin aber abnimmt.

Im Stand der Technik existieren mehrere Verfahren und Anlagen, mit deren Hilfe versucht werden kann, einen Einfluss auf den Bondvorgang zu nehmen, wie beispielsweise die Druckschriften EP2656378B1, WO2014191033A1 oder PCT/EP2016056249.

Eine der größten Herausforderungen beim Bonden besteht beim Bondvorgang selbst, also während der Bondinitiierung bis zur vollständigen Kontaktierung der Kontaktflächen der Substrate. Hierbei kann sich die Ausrichtung der beiden Substrate zueinander gegenüber der vorherigen Ausrichtung noch maßgeblich ändern. Sind die beiden Substratoberflächen erst einmal miteinander verbunden, ist eine Trennung zwar theoretisch wieder möglich, allerdings mit hohen Kosten, geringem Durchsatz und Fehleranfälligkeit verbunden.

Aufgabe der vorliegenden Erfindung ist es, eine Vorrichtung und ein Verfahren zum Bonden zweier Substrate vorzusehen, mit welchen die Bondgenauigkeit, insbesondere über die gesamte Fläche, erhöht wird.

Die vorliegende Aufgabe wird mit den Merkmalen der nebengeordneten Ansprüche gelöst. Vorteilhafte Weiterbildungen der Erfindung sind in den Unteransprüchen angegeben. In den Rahmen der Erfindung fallen auch sämtliche Kombinationen aus zumindest zwei in der Beschreibung, in den Ansprüchen und/oder den Zeichnungen angegebenen Merkmalen. Bei angegebenen Wertebereichen sollen auch innerhalb der genannten Grenzen liegende Werte als Grenzwerte offenbart gelten und in beliebiger Kombination beanspruchbar sein.

Es wird erfindungsgemäß vorgeschlagen ein Verfahren zum Bonden eines ersten Substrats mit einem zweiten Substrat an einander zugewandten Kontaktflächen der Substrate mit folgenden Schritten, insbesondere folgendem Ablauf:
- Aufnahme des ersten Substrats an einer ersten Aufnahmefläche einer ersten Aufnahmeeinrichtung und Aufnahme des zweiten Substrats an einer zweiten Aufnahmefläche einer zweiten Aufnahmeeinrichtung,
- Befestigung der Substrate an den Aufnahmeflächen durch Fixierelemente,
- Krümmung mindestens einer der Kontaktflächen vor einer Kontaktierung der Kontaktflächen,
   wobei,
   nach der Kontaktierung zunächst nur diejenigen Fixierelemente abgeschaltet werden, die uniaxial entlang einer einzigen Kontaktierungsachse angeordnet sind, und die übrigen Fixierelemente eingeschaltet bleiben, sodass die Substrate zunächst lediglich uniaxial entlang der Kontaktierungsachse miteinander verbunden werden,
   wobei danach die übrigen Fixierelemente abgeschaltet werden, sodass die Substrate vollflächig miteinander verbunden werden.

Das erfindungsgemäße Verfahren erlaubt vorteilhaft eine Reduzierung der Verzerrung beim Bonden der Substrate, da zunächst nur entlang der Kontaktierungsachse verbunden wird, sodass lediglich uniaxiale Verzerrungen auftreten können.

In einer bevorzugten Ausführungsform ist es vorgesehen, dass die Fixierelemente rasterförmig angeordnet sind, wobei bevorzugt die Abstände benachbarter Fixierelemente konstant sind. Vorteilhaft können die Fixierelemente gleichmäßiger verteilt werden, sodass eine bessere Kontrolle des Bondens entlang der Kontaktierungsachse erreicht werden kann.

In einer weiteren Verbesserung sind die Fixierelemente rechteckig ausgebildet und/oder besitzen die Form von miteinander in Deckung zu bringenden Strukturen, die sich auf den Oberflächen der Substrate befinden. Die Fixierelemente können insbesondere kreisringförmig ausgebildet sein.

In einer anderen bevorzugten Ausführungsform ist es vorgesehen, dass die Fixierelemente sequentiell abgeschaltet werden, bevorzugt von innen nach außen und/oder mit gleichem Zeitabstand. Vorteilhaft kann dadurch die Ablösung des Substrats von der Aufnahmeeinrichtung besonders gut gesteuert werden, sodass eine besonders gute Reduzierung der Verzerrungen möglich ist.

In einer bevorzugten alternativen Ausführungsform ist es vorgesehen, dass die Fixierelemente entlang einer Kurve, insbesondere einer Geraden, gleichzeitig abgeschaltet werden. Vorteilhaft ist dadurch eine besonders gleichmäßige Ablösung des Substrats möglich, wodurch die Verzerrungen entlang der Kurve gleichförmig ausgebildet sind.

Gemäß einer anderen bevorzugten Ausführungsform ist es vorgesehen, dass die Krümmung durch ein länglich entlang der Kontaktierungsachse ausgebildetes Verformelement und/oder mehrere entlang der Kontaktierungsachse angeordnete Verformelemente erzeugt wird. Vorteilhaft ist es dadurch möglich, dass sich das Verformelement beziehungsweise die Verformelemente der Kontaktierungsachse anpassen. Dadurch können besonders vorteilhaft die Verzerrungen entlang der Kontaktierungsachse gleichförmig ausgebildet werden. Denkbar ist insbesondere die Verwendung eines einzelnen Verformelements, das insbesondere das Zentrum des Substrats kontaktieren kann.

In einer anderen bevorzugten Ausführungsform ist es vorgesehen, dass die Krümmung konvex erfolgt aus Sicht des gegenüberliegenden Substrats. Vorteilhaft ist es durch die konvexe Krümmung möglich, dass das Substrat in Richtung des gegenüberliegenden Substrats gekrümmt wird. Dadurch ist eine besonders exakte Kontaktierung der Substrate möglich, sodass auch eine weitgehende Reduzierung der Verzerrungen beziehungsweise eine Konzentration der Verzerrungen entlang der Kontaktierungsachse möglich ist.

In einer anderen bevorzugten Ausführungsform ist es vorgesehen, dass die Krümmungen der beiden Substrate spiegelbildlich zueinander erfolgen. Mit spiegelbildlich ist die Spiegelung in Bezug auf die zwischen den Substraten liegende Ebene gemeint. Die Ebene ist insbesondere parallel zu der nach dem Bond entstandenen Bondebene. Vorteilhaft ist eine besonders exakte Kontaktierung möglich, wenn beide Substrate spiegelbildlich zueinander gekrümmt werden, weil die Substrate dann an den jeweils erhabenen Stellen exakt kontaktieren können.

In einer anderen bevorzugten Ausführungsform ist es vorgesehen, dass die Kontaktierungsachse durch das Zentrum eines der Substrate verläuft, bevorzugt durch die Zentren beider Substrate. Vorteilhaft ermöglicht diese Ausführungsform, dass die Kontaktierungsachse zentral durch die Substrate verläuft. Dies ermöglicht vorteilhaft einen zentralen Verlauf der Verzerrungen, sodass die Verzerrungen gleichförmig ausgebildet werden können.

In einer anderen bevorzugten Ausführungsform ist es vorgesehen, dass die Kontaktierung der Substrate in den Zentren der Substrate initiiert wird, wobei bevorzugt die Kontaktierung der Substrate entlang der Kontaktierungsachse vollständig bis zu den Außenrändern der Substrate erfolgt. Dadurch, dass die Kontaktierung entlang der Kontaktierungsachse vollständig bis zu den Außenrändern der Substrate erfolgt, kann entlang der gesamten Breite der Substrate eine uniaxiale Kontaktierung erfolgen. Dadurch können die Verzerrungen möglichst exakt entlang der Kontaktierungsachse ausgebildet werden.

In einer anderen bevorzugten Ausführungsform ist es vorgesehen, dass die Fixierung der Substrate ausschließlich an deren Außenrändern erfolgt. Vorteilhaft ist dadurch eine Fixierung im Zentrum der Substrate nicht erforderlich, wodurch die Fixierung erheblich vereinfacht werden kann. Dadurch wird außerdem die Ablösung erleichtert, weil die Ablösung im Zentrum nicht oder nur sehr geringfügig gesteuert werden muss.

In einer anderen bevorzugten Ausführungsform ist es vorgesehen, dass die Fixierelemente in mehreren Zonen zusammengefasst sind, wobei die Zonen separat ein- und ausschaltbar sind und/oder an den Außenrändern der Substrate angeordnet sind, wobei die Zonen bevorzugt in gleichmäßigem Abstand zueinander verteilt an den Außenrändern der Substrate angeordnet sind. Vorteilhaft können durch die Zonen größere Bereiche ein- und abgeschaltet werden. Dadurch ist es möglich, die Steuerung der Ablösung beziehungsweise der Fixierelemente zu vereinfachen. Wenn die Zonen insbesondere in gleichmäßigem Abstand zueinander verteilt in den Außenrändern der Substrate angeordnet sind, kann durch die entsprechende Auswahl der abzuschaltenden Zonen die Ablösung besonders gut beeinflusst werden. Insbesondere wenn in Bezug auf die Zentren der Substrate gegenüberliegende Zonen abgeschaltet werden, kann eine uniaxiale Ablösung der Substrate erfolgen.

Erfindungsgemäß vorgesehen ist weiterhin eine Vorrichtung zum Bonden eines ersten Substrats mit einem zweiten Substrat an einander zugewandten Kontaktflächen der Substrate mit:
- einer ersten Aufnahmeeinrichtung zur Aufnahme des ersten Substrats an einer ersten Aufnahmefläche und einer zweiten Aufnahmeeinrichtung zur Aufnahme des zweiten Substrats an einer zweiten Aufnahmefläche,
- Krümmungsmitteln zur Krümmung mindestens einer der Kontaktflächen vor einer Kontaktierung der Kontaktflächen,
wobei
die Vorrichtung Steuermittel aufweist, sodass nach der Kontaktierung zunächst nur diejenigen Fixierelemente abschaltbar sind, die uniaxial entlang einer einzigen Kontaktierungsachse angeordnet sind, und die übrigen Fixierelemente eingeschaltet bleiben können, sodass die Substrate zunächst lediglich uniaxial entlang der Kontaktierungsachse miteinander verbindbar sind,
wobei danach die übrigen Fixierelemente abschaltbar sind, sodass die Substrate vollflächig miteinander verbindbar sind.

Der Erfindung liegt der Gedanke zugrunde, die Fixierelemente, insbesondere Saugelemente, derart abzuschalten, dass das Substrat zunächst entlang lediglich einer einzigen Achse bzw. einer einzigen Richtung abgelöst wird. Dadurch verformt sich das Substrat auch lediglich entlang dieser Achse bzw. Richtung. Die Bondwelle nimmt eine im Wesentlichen rechteckige Form an. Die Substrate bonden zunächst lediglich entlang dieser Achse bzw. Richtung, insbesondere von den Zentren weg bis zu den Außenkanten der Substrate. Dadurch können vorteilhaft die Verzerrungen der Substrate minimiert werden, wodurch die Bondgenauigkeit erheblich verbessert werden kann.

Merkmale, Ausführungsformen, Definitionen und Aspekte die für das Verfahren gelten sollen auch für die Vorrichtung gelten und umgekehrt.

In einer bevorzugten Ausführungsform und/oder als eigenständige Erfindung können Zonen mit Fixierelementen so ein- bzw. ausgeschalten werden, dass die Durchbiegung des Substrats bzw. der Substrate gezielt beeinflusst werden kann. Dabei sind die Zonen insbesondere ausschließlich am Außenrand der Substrate angeordnet.

Insbesondere wird die Durchbiegung derart durch die Schaltung der Zonen beeinflusst, dass sich eine Abweichung der symmetrischen Durchbiegung eines Substrats ergibt. Insbesondere nimmt die Symmetrie der Durchbiegung ab. Denkbar ist, dass beim Ausschalten von mehreren Zonen Durchbiegungen des Substrats erfolgen, welche eine
- lineare bzw. uniaxiale
- n-förmige, insbesondere
   ∘ dreieckige
   ∘ quadratische
   ∘ fünfeckige
   ∘ sechseckige
   ∘ siebeneckige
   ∘ achteckige
sternförmige Symmetrie aufweisen. Die Symmetrie der Durchbiegung kann so eingestellt werden, dass beim Voranschreiten der Bondwelle ein möglichst minimaler "run-out" entsteht.

Der Erfindung liegt weiterhin insbesondere der Gedanke zugrunde, dass mindestens eines der Substrate vor der Kontaktierung oder dem Bonden, insbesondere uniaxial, gekrümmt wird und die Krümmung mindestens eines der beiden Substrate während des Bondens, insbesondere während des Laufs einer Bondwelle, vorzugsweise beim Fusionsbonden, durch Steuerung der Krümmung geändert wird. Die Krümmung des anderen (vorzugsweise oberen) Substrats wird vorzugsweise auch geändert, insbesondere aber ohne exakte Steuerung der Krümmungsänderung, sondern vorzugsweise durch selbsttätiges Kontaktieren dieses Substrats. Das selbsttätige Kontaktieren erfolgt insbesondere durch die auf das Substrat wirkende Gewichtskraft und/oder sonstige Anziehungskräfte zwischen den Substraten. Die Steuerung der Krümmungsänderung des einen (insbesondere unteren) Substrats erfolgt insbesondere analog der Krümmungsänderung des anderen (insbesondere oberen) Substrats, vorzugsweise in Abhängigkeit (bevorzugt durch Messung und Regelung) von dessen Krümmungsänderung. Denkbar ist auch, dass eines der beiden Substrate, insbesondere das untere Substrat, keine spiegelbildliche Krümmung zum anderen, insbesondere oberen, Substrat besitzt, insbesondere sogar vollkommen flach fixiert ist.

Mit Krümmungsänderung ist insbesondere ein von einem Ausgangszustand (insbesondere die vor dem Kontaktieren eingestellte Krümmung) der Substrate abweichender Zustand gemeint. Erfindungsgemäß wird das Bonden nach einer Kontaktierung der Kontaktflächen, insbesondere durch kontrollierte Steuerung einer Fixierung der Substrate, gesteuert. Entsprechende Fixiermittel sind vorrichtungsgemäß insbesondere vorgesehen.

Ein weiterer, insbesondere eigenständiger, Aspekt der vorliegenden Erfindung besteht in der Anwendung von, insbesondere einzeln schaltbaren Fixiermitteln, mit deren Hilfe eine sich fortschreitende Bondwelle zwischen den Kontaktflächen kontrolliert gesteuert oder geregelt werden kann.

Besonders gute Ergebnisse erzielt man insbesondere dann, wenn die Bondwelle an allen Punkten des Randes der Substrate gleichzeitig ankommt. Insbesondere wird dadurch jene Fixierung und jene Zonenschaltung beansprucht, bei der dieses Ergebnis erzielt wird.

Vorzugsweise werden mehrere schaltbare Fixiermittel entlang einer vorgegebenen Kurve, insbesondere einer Geraden, gleichzeitig abgeschaltet, sodass das Substrat uniaxial gekrümmt wird.

Die Krümmung kann durch die Gravitation und/oder mindestens ein Verformelement erzeugt werden.

Eine weitere, insbesondere eigenständige, oder mit der vorgenannten kombinierbare, erfindungsgemäße Idee besteht in der Verwendung mindestens eines Verformelements als Krümmungsmittel und/oder Krümmungsänderungsmittel, das insbesondere als Gasaustrittsöffnung ausgebildet wird. Dadurch unterbleibt ein mechanischer Kontakt zum Substrat. Die Kontrolle der Krümmung erfolgt durch Kombination der vorgenannten Merkmale noch genauer.

Da das Substrat erfindungsgemäß uniaxial gekrümmt werden soll, kann das Verformelement erfindungsgemäß ebenfalls länglich geformt sein. Denkbar ist allerdings auch die Verwendung eines Verformungsmittels, welches das Substrat punktförmig beanspruchen kann. Eine weitere Möglichkeit stellen mehrere Verformungsmittel dar, die sich entlang einer Kurve, insbesondere einer Geraden im Probenhalter verbaut sind.

Die Erfindung beschreibt insbesondere ein Verfahren und eine Vorrichtung, mit deren Hilfe zwei zueinander ausgerichtete Substrate optimal miteinander verbondet werden können. Der Idee liegt dabei vor allem der Gedanke zu Grunde, durch eine gezielte Kontrolle, Steuerung oder Regelung der Krümmung, Fixierung und/oder Loslösung mindestens eines der beiden Substrate die fortschreitende Bondwelle so zu kontrollieren, zu steuern oder regeln, dass eine optimale, sequentielle, insbesondere entlang einer Richtung fortschreitende, Kontaktierung der beiden Substrate entlang der Kontaktflächen erfolgt. Im Gegensatz zum Stand der Technik werden die Fixiermittel daher so geschalten, dass sich eine uniaxiale Krümmung der Substrate ergibt. Unter optimaler Kontaktierung versteht man insbesondere, dass der "run-out" Fehler an jeder Stelle der Kontaktgrenzfläche zwischen den beiden Substraten, minimal ist oder im optimalen Fall sogar verschwindet.

Gemäß einer Ausführungsform ist eine Fixierung der Substrate durch mehrere, insbesondere in Zonen gegliederte, Fixiermittel vorgesehen.

Gemäß einer weiteren Ausführungsform ist die Krümmung mindestens eines der Substrate mittels Überdruck vorgesehen.

Im Ausgangszustand sind die Substrate im Regelfall, insbesondere an einer Kontaktfläche, mehr oder weniger eben, abgesehen von etwaigen die Kontaktfläche überragenden Strukturen (Mikrochips, funktionale Bauteile) und Substrattoleranzen wie Biegung und/oder Dickenschwankungen. Die Substrate besitzen im Ausgangszustand aber in den meisten Fällen eine von Null verschiedene Krümmung. Für einen 300 mm Wafer sind Krümmungen von weniger als 100 µm üblich. Mathematisch gesehen kann eine Krümmung als ein Maß für die lokale Abweichung einer Kurve von ihrem ebenen Zustand angesehen werden. Im konkreten Fall werden Substrate betrachtet, deren Dicken gering im Vergleich zum Durchmesser sind. Daher kann man in guter Näherung von der Krümmung einer Ebene sprechen. Im Fall einer Ebene ist der anfangs erwähnte, ebene Zustand die Tangentialebene der Kurve im Punkt, an welchem man die Krümmung betrachtet.

Im Allgemeinen besitzt ein Körper, im speziellen Fall das Substrat, keine homogene Krümmung, so dass die Krümmung eine explizite Funktion des Ortes ist. So kann es beispielsweise sein, dass ein nicht ebenes Substrat im Zentrum eine konkave Krümmung, an anderen Stellen allerdings eine konvexe Krümmung aufweist. Erfindungsgemäß ist mit Krümmung oder Krümmungsänderung - soweit nichts Anderes beschrieben ist - eine makroskopische, also auf das gesamte Substrat beziehungsweise die Kontaktfläche bezogene Krümmung oder Krümmungsänderung gemeint.

Unter einer uniaxialen Krümmung versteht man eine Krümmung, die das Substrat nur entlang einer Dimension bzw. Achse verkrümmt. Entsprechend ergeben sich daraus auch vereinfachte, insbesondere uniaxiale, Dehnungs- und Spannungszustände (Spannungszustände in Normalenrichtung des Substrats werden dabei vernachlässigt). Insbesondere bei rechteckigen Strukturen auf den Substraten wirken sich uniaxiale Dehnungszustände extrem positiv auf die Reduktion des "run-out" Fehlers aus, da der "run-out" Fehler nur mehr entlang einer Dimension korrigiert werden muss.

Erfindungsgemäß bevorzugt sind konvexe Krümmungen, jeweils aus Sicht des gegenüberliegenden Substrats. Noch bevorzugter verlaufen die Krümmungen der beiden Substrate spiegelbildlich zueinander.

Eine weitere Möglichkeit die Krümmung an einem Punkt anzugeben besteht darin, den Krümmungsradius anzugeben. Der Krümmungsradius ist der Radius eines, an die Oberfläche angeschmiegten, den betrachteten Oberflächenpunkt beinhaltenden, Kreises.

Ein, insbesondere eigenständiger, Kerngedanke für die meisten erfindungsgemäßen Ausführungsformen besteht somit darin, dass die Krümmungsradien der zwei miteinander zu verbondenden Substrate zumindest im Kontaktierungsbereich der Substrate, also an einer Bondfront der Bondwelle bzw. an der Bondlinie gleich sind, oder zumindest nur marginal voneinander abweichen. Die Differenz der beiden Krümmungsradien an der Bondfront/Bondlinie der Substrate ist dabei kleiner als 10m, mit Vorzug kleiner als 1m, mit größerem Vorzug kleiner als 1cm, mit größtem Vorzug kleiner als 1mm, mit allergrößtem Vorzug kleiner als 0.01mm, am bevorzugtesten kleiner als 1µm. Im Allgemeinen sind alle erfindungsgemäßen Ausführungsformen von Vorteil, welche die Krümmungsradien R1, R2 minimieren.

Ein weiterer wichtiger Kerngedanke für die genannten erfindungsgemäßen Ausführungsformen besteht darin, dass eine Abschaltung der Fixiermittel entlang einer, insbesondere linearen, Linie erfolgt, sodass ein, im Allgemeinen multiaxialer Spannungs- bzw. Dehnungszustand, des Substrats in einen uniaxialen Spannungs- bzw. Dehnungszustand übergeht. Durch die Umwandlung eines multiaxialen in einen uniaxialen Spannungs- bzw. Dehnungszustand muss der run-out insbesondere nur mehr für eine Dimension korrigiert werden.

Mit anderen Worten: Die Erfindung betrifft insbesondere eine Methode und eine Anlage, mit deren Hilfe man in der Lage ist, zwei Substrate so miteinander zu verbonden, dass deren lokale Ausrichtungsfehler, die man als "run-out" Fehler bezeichnet, minimal werden. Die unterschiedlichen run-out Fehler werden ausführlich in der WO2014191033A1 beschrieben und referenziert.

Der Erfindung liegt dabei weiterhin insbesondere der Gedanke zu Grunde, die Krümmungen/Krümmungsänderungen beiden miteinander zu verbondenden Substrate, insbesondere durch eine, insbesondere über weite Flächenteile, kontrollierbare Fixierung so zu steuern, dass die Einflussfaktoren auf die sich ausbildende Bondwelle so gewählt werden, dass die beiden Substrate sich während des Bondens lokal nicht zueinander verschieben, also richtig ausgerichtet bleiben. Des Weiteren beschreibt die Erfindung einen Artikel, bestehend aus zwei miteinander verbondeten Substraten mit erfindungsgemäß reduziertem "run-out" Fehler.

Ein erfindungsgemäß charakteristischer Vorgang beim Bonden, insbesondere Permanentbonden, vorzugsweise Fusionsbonden, ist die möglichst kurvenförmige, insbesondere lineare, Kontaktierung der beiden Kontaktflächen der Substrate. Bevorzugt wird die Kontaktierungslinie bzw. die Kontaktierungsachse das Zentrum mindestens eines der Substrate treffen. Die Distanz zwischen der Kontaktierungslinie bzw. der Kontaktierungsachse und dem Zentrum des Substrats bzw. der Substrate ist erfindungsgemäß insbesondere kleiner als 100mm, mit Vorzug kleiner als 10mm, mit größerem Vorzug kleiner als 1mm, mit größtem Vorzug kleiner als 0.1mm, mit allergrößtem Vorzug kleiner als 0.01mm. Im weiteren Verlauf der Beschreibung soll unter Kontaktierung im Regelfall eine linienförmige Kontaktierung gemeint sein. Unter Linie versteht man im weiteren Sinne mit Vorzug eine beliebige eindimensionale Kontur.

Um eine Initiierung der, insbesondere linienförmigen, Kontaktierung zu gewährleisten wird gemäß einer Ausführungsform der Erfindung eine mit einer zentrischen Bohrung und einem darin translatorisch bewegbaren Stift als Krümmungsmittel und/oder Krümmungsänderungsmittel versehene Aufnahmeeinrichtung (Substrathalter) versehen. Denkbar wäre auch die Verwendung einer Düse als Krümmungsmittel und/oder Krümmungsänderungsmittel, welche ein Fluid, mit Vorzug ein Gas an Stelle des Stifts zur, insbesondere direkten, Fluiddruckbeaufschlagung des Substrats verwendet (Fluiddruckbeaufschlagungsmittel). Des Weiteren kann sogar vollständig auf die Verwendung derartiger Elemente verzichtet werden, wenn man Vorrichtungen vorsieht, welche die beiden Substrate durch eine Translationsbewegung aneinander annähern können unter der weiteren Voraussetzung, dass beide Substrate, insbesondere auf Grund der Gravitation und/oder einer Vorspannung, eine aufgeprägte Krümmung in Richtung des anderen Substrats besitzen. Die Substrate kontaktieren bei der translatorischen Annäherung, bei genügend geringem Abstand zum entsprechenden zweiten Substrat automatisch.

Bei den Fixierelementen handelt es sich gemäß einer Ausführungsform der Erfindung entweder um angebrachte Vakuumlöcher, eine oder mehrere kreisrunde Vakuumlippen oder vergleichbare Vakuumelemente, mit deren Hilfe der Wafer fixiert werden kann. Denkbar ist auch die Verwendung mehrerer elektrostatischer Fixierelemente (Fixiermittel). Der Stift in der zentrischen Bohrung oder eine Leitung, aus dem ein Überdruck, durch ein eingeleitetes Gas, zwischen dem Substrathalter und dem Substrat erzeugt werden kann, dienen der steuerbaren Durchbiegung des fixierten Substrats (Krümmungsmittel und/oder Krümmungsänderungsmittel).

Nach der erfolgten Kontaktierung der Zentren beider Substrate werden die Fixiermittel der Aufnahmeeinrichtungen insbesondere so angesteuert, dass eine kontrollierte Verformung/Krümmungsänderung zumindest eines der Substrate erfolgt. Erfindungsgemäß erfolgt die Abschaltung der Fixierelemente dabei entlang einer, insbesondere geraden, Linie, sodass ein uniaxialer Spannungs- bzw.-Dehnungszustand entsteht. Ein oberes Substrat wird einerseits durch die Schwerkraft und andererseits bedingt durch eine entlang der Bondwelle und zwischen den Substraten wirkende Bondkraft kontrolliert nach unten gezogen. Das obere Substrat wird somit entlang der, durch die abgeschalteten Fixiermittel definierten Linie, vom Zentrum mit dem unteren Substrat verbunden. Es kommt so zu einer erfindungsgemäßen Ausbildung einer im Allgemeinen nichtradialsymmetrischen Bondwelle, die insbesondere vom Zentrum startet. Während des Bondvorganges drücken die beiden Substrate das zwischen den Substraten vorliegende Gas, insbesondere Luft, vor der Bondwelle her und sorgen damit für eine Bondgrenzfläche ohne Gaseinschlüsse. Ein oberes Substrat liegt dann, sofern es vollständig fallen gelassen wird, praktisch auf einer Art Gaspolster. Ab einem definierten Zeitpunkt können alle Fixierelemente des Substrathalters ausgeschaltet werden, sodass das obere Substrat unterem dem Einfluss der Schwerkraft und/oder der Anziehungskräfte zwischen den Substraten sich selbst überlassen wird. Zu diesem Zeitpunkt wird die Krümmungsänderung des oberen Substrats nicht mehr gesteuert oder geregelt, läuft aber nach wie vor kontrolliert ab, da die Rahmenbedingungen bekannt sind oder empirisch ermittelt worden sind. Auf Basis dieser kontrollierten Krümmungsänderung und Fortschreiten der Bondwelle wird die Krümmungsänderung des unteren Substrats gesteuert oder geregelt. Die erfindungsgemäße bevorzugte Ausführung besteht aber nicht im Fallenlassen des oberen Substrats sondern in einer vollständigen Kontrolle der beiden Substrate bis sich die Bondwelle zumindest über mehr als 10%, vorzugsweise mehr als 20%, noch bevorzugter mehr als 30%, am bevorzugtesten mehr als 50%, am allerbevorzugtesten mehr als 75% der Fläche der Substrate ausgebreitet hat.

Ab dem vorgenannten Zeitpunkt, bei dem alle Fixierelemente der oberen Aufnahmeeinrichtung ausgeschaltet wurden, bedarf es insbesondere keiner zusätzlichen Fixierung. Das obere Substrat kann sich also abgesehen von der Fixierung an der Bondinitiierungsstelle frei bewegen und auch verzerren. Durch die erfindungsgemäß voranschreitende Bondwelle, die an der Bondwellenfront auftretenden Spannungszustände und die vorliegenden geometrischen Randbedingungen wird jedes bezüglich seiner radialen Dicke infinitesimal kleine Kreissegment einer Verzerrung unterliegen. Da die Substrate allerdings starre Körper darstellen, summieren sich die Verzerrungen als Funktion des Abstandes vom Zentrum her auf. Dies führt zu "run-out" Fehlern, die durch das erfindungsgemäße Verfahren und die erfindungsgemäße Vorrichtung beseitigt werden. Denkbar ist auch, dass das obere Substrat während dem gesamten Zeitabschnitt, in dem die Bondwelle läuft, fixiert gehalten wird und ein Fortschreiten der Bondwelle durch ein sukzessives Ausschalten der Fixierelemente, insbesondere beginnend mit den Fixierelemente im Inneren des Substrathalters voranschreiten kann. Ein Fortlaufen der Bondwelle kann insbesondere auch dadurch begünstigt werden, dass während dem Fortschreiten der Bondwelle eine relative Annäherung der beiden Substrathalter zueinander erfolgt.

Der Abstand zwischen den Substraten vor der Kontaktierung liegt zwischen 0 und 10 mm, vorzugsweise zwischen 0 und 1000 µm, noch bevorzugter zwischen 0 und 500 µm, am allerbevorzugtesten zwischen 0 und 100 µm.

In einer weiteren erfindungsgemäßen Ausführungsform wird, insbesondere das obere Substrat, nur an einer endlichen Anzahl von Positionen über erfindungsgemäße Fixierelemente von Zonen fixiert, sodass sich, insbesondere durch die Gravitation und/oder ein Verformelement, eine von der Radialsymmetrie stark abweichende Durchbiegung mit niedriger Symmetrie ergibt. In diesem Fall versteht man unter dem Abstand die geringstmögliche Distanz zwischen den Substraten.

Die Erfindung betrifft somit insbesondere ein Verfahren und eine Vorrichtung, um den "run-out"-Fehler zwischen zwei gebondeten Substraten, insbesondere durch thermodynamische und/oder mechanische Kompensationsmechanismen, beim Bonden zu verringern oder sogar ganz zu vermeiden.

Des Weiteren betrifft die Erfindung einen entsprechenden Artikel, der mit der erfindungsgemäßen Vorrichtung und dem erfindungsgemäßen Verfahren hergestellt wird.

### Aufnahmeeinrichtung/Substrathalter

Die erfindungsgemäßen Substrathalter verfügen über Fixiermittel, insbesondere mehrere Fixierelemente. Die Fixierelemente können in Zonen gruppiert sein. Eine Gruppierung der Fixierelemente in Zonen erfüllt entweder eine geometrische, optische vorzugsweise aber eine funktionelle Aufgabe. Unter einer funktionellen Aufgabe wäre beispielsweise zu verstehen, dass alle Fixierelemente einer Zone gleichzeitig geschaltet werden können. Denkbar ist auch, dass alle Fixierelemente in einer Zone individuell geschalten werden können. So können mehrere Fixierelemente gleichzeitig zur Fixierung bzw. zum Lösen des Substrats innerhalb der Zone angesteuert werden oder sie können zwar individuell angesteuert werden, erzeugen aber in ihrer Zone eine sehr individuelle Verformungseigenschaft des Substrats.

Die Zonen können insbesondere folgende Geometrien annehmen:
- Einflächig,
- Kreissegment,
- Gekachelt, insbesondere als Dreieck, Viereck oder Sechseck.
- Kreisringsegment

Insbesondere können sich zwischen den Zonen auch Flächen ohne Fixierelemente befinden. Der Abstand zwischen solchen Zonen ist insbesondere kleiner als 150 mm, vorzugsweise kleiner als 50 mm, noch bevorzugter kleiner als 20 mm, am bevorzugtesten kleiner als 10 mm, am allerbevorzugtesten kleiner als 5mm. Sind die Zonen als Kreissegmente ausgelegt, dann wäre der Abstand die Distanz zwischen dem inneren Kreisring eines äußeren Kreissegments und dem äußeren Kreisring eines inneren Kreissegments.

Kreisringsegmente, die näher am Zentrum liegen, werden vorzugsweise kleiner ausgeführt als Kreisringsegmente am Rand.

Die Anzahl der Fixierelemente pro Zone ist beliebig. Insbesondere befinden sich in einer Zone mehr als 1 Fixierelement, vorzugsweise mehr als 10, bevorzugter mehr als 50, noch bevorzugtesten mehr als 100, am bevorzugtesten mehr als 200, am allerbevorzugtesten mehr als 500.

Gemäß einer vorteilhaften Ausführungsform der Erfindung weist die erste Aufnahmeeinrichtung und/oder die zweite Aufnahmeeinrichtung, insbesondere ringförmig, vorzugsweise kreisringförmig, am Umfang von Aufnahmeflächen der ersten Aufnahmeeinrichtung und/oder der zweiten Aufnahmeeinrichtung zur Aufnahme der Substrate, insbesondere ausschließlich im Bereich von Seitenrändern der Substrate, angeordnete Fixiermittel auf.

Die Fixiermittel sind als, insbesondere gleichmäßig an den Aufnahmeflächen verteilt, vorzugsweise konzentrisch, angeordnete, in Zonen gegliederte, insbesondere separat steuerbare, Fixierelemente ausgebildet. Vorzugsweise sind die Fixiermittel, insbesondere ausschließlich, in einem Randbereich der Aufnahmefläche angeordnet. Der Randbereich erstreckt sich insbesondere bis zum halben Radius, vorzugsweise bis zu einem Viertel des Radius, der Aufnahmefläche.

Bei einer radialsymmetrischen Anordnung der Fixierelemente in einer Zone, können auch die Anzahl der Fixierelemente pro Querschnitt betrachtet werden. Die Anzahl der Fixierelemente im Querschnitt ist dabei kleiner als 20, vorzugsweise kleiner als 10, noch bevorzugter kleiner als 5, am bevorzugtesten kleiner als 3, am allerbevorzugtesten 1.

Die Fixierelemente sind mit Unterdruck zur Fixierung beaufschlagbar, können zum Loslösen des Substrats auch mit Überdruck beaufschlagt werden.

In einer ersten erfindungsgemäßen Ausführungsform bestehen die Fixierelemente aus einfachen, insbesondere durch Bohrung oder Funkenerosion erzeugten, Löchern. In einer speziellen Ausführungsform sind die Fixierelemente ringförmige, insbesondere kreisringförmig, insbesondere durch einen Fräsprozess erzeugte, Schlitze. In Weiterbildung können die Fixierelemente mit Vakuumlippen versehen werden. Sind die Fixierelemente als Vakuumelemente vorgesehen, so können Sie einen Druck von weniger als 200mbar, vorzugsweise weniger als 100 mbar, noch bevorzugter 50 mbar, am bevorzugtesten weniger als 10 mbar, am allerbevorzugtesten weniger als 1 mbar erzeugen.

Neben der Steuerung des Drucks kann auch der Massenstrom durch die Vakuumelemente gesteuert werden. Der Massenstrom ist die Masse, die pro Zeiteinheit einen Querschnitt passiert. Die Masse setzt sich zusammen aus den Einzelmassen der Moleküle und Atome, welche durch die Vakuumelemente gesaugt und/oder gepumpt werden. Der Massenstrom für ein einzelnes Vakuumelement liegt zwischen 0 kg/s und 1 kg/s, vorzugsweise zwischen 0 kg/s und 0.5 kg/s, noch bevorzugter zwischen 0 kg/s und 0.1 kg/s, am bevorzugtesten zwischen 0 kg/s und 0.01 kg/s, am allerbevorzugtesten zwischen 0 kg/s und 0.001 kg/s.

In einer zweiten erfindungsgemäßen Ausführungsform bestehen die Fixierelemente aus leitfähigen Platten, die als elektrostatische Fixierung verwendet werden. Die leitfähigen Platten können unipolar, vorzugsweise aber bipolar geschaltet werden. Bei einer bipolaren Schaltung werden zwei Platten auf wechselseitiges Potential gelegt. Der erfindungsgemäße Substrathalter wirkt dann in seinen Zonen als elektrostatischer Substrathalter mit einer, abhängig von der Anzahl der Platten, hochaufgelösten elektrostatischen Fixiereigenschaft.

Je größer die Anzahl der Fixierelemente pro Einheitsfläche, desto besser die Steuerung der Fixiereigenschaft des Substrathalters für das Substrat.

Mit Vorteil werden die erste Aufnahmefläche und/oder die zweite Aufnahmefläche aus, insbesondere eine erste Aufnahmeebene der ersten Aufnahmefläche und eine zweite Aufnahmeebene der zweiten Aufnahmefläche bildenden, Erhebungen gebildet.

Als Erhebungen kommen insbesondere spiralförmig verlaufende Bahnen in Frage.

Gemäß zwei weiteren Ausführungsformen werden Aufnahmeeinrichtungen mit Erhebungen, insbesondere Noppensubstrathalter, beschrieben. Unter einem solchen Substrathalter versteht man einen Substrathalter, der über mehrere, insbesondere symmetrisch angeordnete, Stützen (engl.: pillars) verfügt. Diese Stützen werden insbesondere als Noppen ausgeführt. Die Noppen können beliebige Formen besitzen. Insbesondere vorgesehen sind Noppen in der Form von:
- Pyramiden, insbesondere dreiseitigen oder vierseitigen Pyramiden,
- Zylindern, insbesondere mit flachem oder abgerundetem Kopf,
- Quadern,
- Kegeln,
- Kugelschalen.

Kugelschalennoppen, Kegelnoppen und Zylindernoppen sind aufwendig herzustellen, wohingegen pyramidenförmige oder quaderförmige Noppen durch Ätz- und/oder Fräsprozesse relativ einfach gefertigt werden können und somit erfindungsgemäß bevorzugt sind.

Die genannten Noppensubstratprobenhalter können an Ihrer Peripherie über ein Randelement abgeschlossen sein, sodass die Raumbereiche zwischen den Noppen als Vertiefungen interpretiert werden können. Möglich ist aber auch, dass die Noppen die einzigen Erhöhungen in Bezug zur Noppenebene darstellen, auf denen alle Noppen vorhanden sind.

In einer dritten bevorzugten erfindungsgemäßen Ausführungsform wird der Substrathalter als Noppensubstrathalter mit Stegen ausgeführt. Die einzelnen Zonen werden hierbei durch Stege unterbrochen. Innerhalb einer jeden Zone endet mindestens eine Leitung, die eine Evakuierung des Raumes zwischen den Noppen gestattet. Durch die Verwendung mehrerer, insbesondere individuell ansteuerbarer, Kanäle ist eine örtlich abhängige, unterschiedlich starke, Evakuierung des Raumes möglich.

In einer vierten, noch bevorzugteren Ausführungsform wird der Substrathalter als vollständiger Noppensubstrathalter, also ohne Stege, ausgeführt.

Die Breite bzw. der Durchmesser der Erhebungen, insbesondere Noppen, ist insbesondere kleiner als 5mm, vorzugsweise kleiner als 1mm, noch bevorzugter kleiner als 500µm, am bevorzugtesten kleiner als 200µm mm.

Die Höhe der Erhebungen, insbesondere Noppen, ist insbesondere kleiner als 2mm, vorzugsweise kleiner als 1 mm, noch bevorzugter kleiner als 500µm, am bevorzugtesten kleiner als 200µm.

Insbesondere ist das Verhältnis zwischen der Breite bzw. dem Durchmesser der Erhebungen und der Höhe der Erhebungen größer als 0.01, vorzugsweise größer als 1, noch bevorzugter größer als 2, am bevorzugtesten größer als 10, am allerbevorzugtesten größer als 20.

Alle genannten erfindungsgemäßen Ausführungsformen können auch beliebig miteinander kombiniert werden. So ist es denkbar, dass eine erste Zone aus elektrostatisch arbeitenden Fixierelementen besteht, und eine zweite Zone Vakuumfixierungen besitzt.

Ein erfindungsgemäßer Substrathalter kann insbesondere über Löcher, im weiteren Verlauf der Druckschrift als Vermessungslöcher bezeichnet, verfügen, die eine Betrachtung der fixierten Substratoberfläche von der Rückseite des Substrathalters erlauben. Dadurch wird eine Vermessung der fixierten Substratoberfläche in diesem Bereich ermöglicht. Die Vermessungslöcher können auch mittels eines Deckels verschlossen werden. In einer ganz besonders bevorzugten Ausführungsform lassen sich die Vermessungslöcher mit dem Deckel vollautomatisch öffnen oder schließen.

Gemäß einer vorteilhaften Ausgestaltung der Erfindung weist die Aufnahmeeinrichtung Krümmungsmessmittel zur Messung der Krümmung auf.

Ein erfindungsgemäßer Substrathalter kann alternativ oder zusätzlich über Sensoren verfügen, mit deren Hilfe physikalische und/oder chemische Eigenschaften zwischen dem fixierten Substrat und dem Substratprobenhalter vermessen werden können. Bei den Sensoren handelt es sich vorzugsweise um
- Temperatursensoren und/oder
- Drucksensoren und/oder
- Abstandssensoren.

Die besonders bevorzugten Abstandssensoren sind als Krümmungsmessmittel einsetzbar, indem vom Abstand zwischen dem Substrat und der Aufnahmeeinrichtung die Krümmung des Substrats ermittelt, insbesondere zwischen Stützstellen interpoliert und/oder berechnet, wird.

Erfindungsgemäß bevorzugt werden, insbesondere entlang der Aufnahmefläche verteilte, Abstandssensoren verwendet, um eine bessere Steuerung oder sogar Regelung der Krümmung und/oder Krümmungsänderung zu ermöglichen.

In einer besonders bevorzugten Ausführungsform sind mehrere Sensoren vor allem als Abstandssensoren ausgebildet, um den Abstand des Substrats vor und/oder während des Bondvorgangs in Bezug zu einer Ebene zu vermessen. Bei der Ebene handelt es sich vorzugsweise um die Aufnahmefläche und/oder die Aufnahmefläche, insbesondere eine durch die Erhebungen gebildete Ebene.

Denkbar ist auch, dass sich Sensoren auf unterschiedlichen Ebenen befinden. Vorzugsweise vermessen die Sensoren, insbesondere ausschließlich, die Veränderung eines Abstandes, vorzugsweise quer zur Kontaktfläche, sodass der Bezug auf eine und/oder mehrere Ebenen irrelevant ist. In diesem Fall muss nur die relative, insbesondere örtlich unterschiedliche, Abstandsänderung des Substrats erfasst werden.

Die Vermessung des Abstandes dient vor allem der Prozesssteuerung. Durch die Kenntnis des exakten Krümmungszustandes des Substrats/der Substrate, erfolgt die Ansteuerung/Regelung der erfindungsgemäßen Fixierelemente zur optimalen, insbesondere schrittweisen, Loslösung des Substrats besonders effizient.

Denkbar ist auch, dass mehrere unterschiedliche Sensorarten verbaut werden. In einer besonders bevorzugten Ausführungsform werden Sensoren zur Abstands- und Druckvermessung, insbesondere symmetrisch und gleichverteilt, im Substrathalter verbaut. Dadurch ist eine diskrete, aber flächendeckende Abstandsvermessung und Druckvermessung möglich. Die Druckvermessung ist von besonderem Vorteil, wenn es sich bei dem Verformungselement um ein über eine Leitung eingebrachtes Fluid, insbesondere Gas- oder Gasgemisch handelt.

Soweit eine oder beide Aufnahmeeinrichtungen ohne Krümmungsmessmittel und/oder ohne Sensoren ausgebildet sind, kann die Einstellung und/oder Steuerung der Krümmungen und/oder Krümmungsänderungen auf Basis empirisch ermittelter Parameter erfolgen.

Die erfindungsgemäßen ersten und zweiten Substrathalter verfügen vorzugsweise über mindestens ein, insbesondere zentrisch konstruiertes, Verformungselement zur Krümmung/Krümmungsänderung der Substrate (Krümmungsmittel und/oder Krümmungsänderungsmittel).

Gemäß einer ersten erfindungsgemäßen Ausführungsform handelt es sich bei dem Krümmungselement um einen Stift (engl.: pin). Dieser Stift verfügt über mindestens einen, vorzugsweise genau einen, Freiheitsgrad der Translation entlang der Normalen auf die Aufnahmefläche oder Aufnahmeebene. Denkbar wäre auch, dass der Stift Freiheitsgrade entlang der Aufnahmefläche besitzt, um in x- und/oder y-Richtung kalibriert zu werden. Vorzugsweise ist der Stift in x- und/oder y-Richtung fixierbar. Der Stift kann eine Kraft von 0.01N-1000N, vorzugsweise 0.1N-500N, am bevorzugtesten 0.25-100N, am allerbevorzugtesten zwischen 0.5-10 N aufbringen.

In einer zweiten erfindungsgemäßen Ausführungsform handelt es sich bei dem Verformungselement zur Krümmung/Krümmungsänderung um eine Fluidaustrittsöffnung, über die ein Fluid, insbesondere Gas oder Gasgemisch, zwischen das Substrat und die Aufnahmefläche gespeist werden kann (Fluiddruckbeaufschlagungsmittel). In einer ganz bevorzugten erfindungsgemäßen Ausführungsform ist die Fluidaustrittsöffnung in einem eigenen, insbesondere in x- und/oder y-Richtung beweglichen Teilelement verbaut, sodass eine x- und/oder y-Positionierung der Fluidaustrittsöffnung erfolgen kann. Dadurch wird die Position des Fluidaustritts exakt festgelegt, was ebenfalls Auswirkungen auf ein optimales, erfindungsgemäßes Bondergebnis haben kann. Bei der Fluidaustrittsöffnung handelt es sich im einfachsten Fall um eine Öffnung, die das Ende einer Leitung darstellt. In einer ganz besonders bevorzugten Ausführungsform handelt es sich bei der Fluidaustrittsöffnung um eine Düse. Vorzugsweise kann die Düse elektronisch gesteuert werden, sodass zu jedem Zeitpunkt der Fluiddruck und/oder die Fluidgeschwindigkeit des ausströmenden Fluids gesteuert/reguliert werden kann. Denkbar ist die Verwendung mehrere Düsen, um einen Druckaufbau an mehreren Stellen zwischen dem Substratprobenhalter und dem Substrat zu variieren. Alle Aussagen für eine Düse gelten dann analog für mehrere Düsen. Über die Fluidaustrittsöffnung, insbesondere eine Düse, kann zwischen dem Substrat und dem Substrathalter ein Druck von mehr als 1 mbar, vorzugsweise mehr als 10 mbar, am bevorzugtesten mehr als 100 mbar, noch bevorzugter mehr als 200 mbar, am allerbevorzugtesten mehr als 500 mbar aufgebaut werden.

Alle erfindungsgemäßen Substrathalter können über Ladestifte (engl.: loading pins) verfügen. Ladestifte dienen der Beladung des erfindungsgemäßen Substrathalters mit einem Substrat. Die Ladestifte werden insbesondere durch Bohrungen in der Aufnahmeeinrichtung geführt, wobei die Bohrungen vorzugsweise gegenüber den Ladestiften gedichtet ausgeführt werden.

In einem ersten Prozessschritt werden die Ladestifte ausgefahren. In einem zweiten Prozessschritt wird ein Substrat, insbesondere vollautomatisch, auf den Ladestiften abgelegt. In einem dritten Prozessschritt fahren die Ladestifte ein und bringen das Substrat so mit der Aufnahmefläche in Kontakt. In einem vierten Prozessschritt wird das Substrat durch die Fixierelemente fixiert. Die Ladestifte dienen auch der Entladung eines gebondeten Substratstapels. Die Prozessschrittreihenfolge dreht sich dann entsprechend um. Die Ladestifte können insbesondere Drucksenken darstellen, sofern sie nicht zu den Bohrungen, in denen sie sich bewegen, abgedichtet wurden. In diesem Fall kann die statische Aufrechterhaltung eines Unterdrucks über Vakuumfixierelemente und/oder die statische Aufrechterhaltung eines Überdrucks durch eine Gasaustrittsöffnung nicht möglich sein. Entsprechend wird eine kontinuierliche Evakuierung über die Vakuumfixierelemente und/oder eine kontinuierliche Überdruckerzeugung über die Gasaustrittsöffnung offenbart, die sich vorzugsweise durch eine stationäre, insbesondere laminare, Strömung auszeichnet. Denkbar ist allerdings auch die Verwendung von Dichtungen, sodass ein statischer Druck aufgebaut werden kann, ohne dass es zur Ausbildung einer Strömung kommt.

Der Substrathalter kann grundsätzlich aus jedem beliebigen Material gefertigt werden. Besonders bevorzugt ist eines oder mehrere der folgenden Materialien:
- Metall, insbesondere
   - Reinmetall, insbesondere
      - Aluminium
   - Legierung, insbesondere
      - Stahl, insbesondere
         - niedriglegierter Stahl,
- Keramik, insbesondere
   - Glaskeramik, insbesondere
      - Zerodur,
   - Nitridkeramik, insbesondere
      - Siliziumnitrid,
      - Karbidkeramik, insbesondere• Siliziumkarbid,
- Polymere, insbesondere
   - Hochtemperaturpolymere, insbesondere
      - Teflon,
      - Polyetheretherketon (PEEK).

In einer ganz bevorzugten Ausführungsform wird ein erfindungsgemäßer Noppensubstratprobenhalter mit der Methode aus der Patentschrift EP2655006B1 hergestellt. Das bevorzugte Material ist dabei Siliziumkarbid oder Siliziumnitrid. Die bevorzugte Noppenstruktur ist in diesem Fall eine vierseitige Pyramide.

Die Aufnahmeeinrichtung ist gemäß einer erfindungsgemäßen Ausführungsform bevorzugt heizbar und/oder kühlbar ausgebildet. In diesem Fall erlauben Temperaturregelmechanismen eine Temperierung des Substrats zwischen -50°C und 500°C, vorzugsweise zwischen -25°C und 300°C, am bevorzugtesten zwischen 0°C und 200°C, am allerbevorzugtesten zwischen 10°C und 100°C.

In einer weiteren, erfindungsgemäßen Ausführungsform wird der Substrathalter so ausgebildet, dass das Substrat durch Heiz- und/oder Kühlmittel noch vor der Kontaktierung gezielt verformt werden kann, insbesondere lateral gestaucht oder gedehnt, werden kann, und zwar um den Betrag, der bei der späteren Kontaktierung notwendig ist, um den entstehenden "run-out"-Fehler bestmöglich, im Idealfall vollständig, zu kompensieren. Da die Fixierung des unteren/ersten Substrats in dieser Ausführungsform erst nach der entsprechenden Verformung erfolgt, muss man keinen besonderen Wert auf die thermischen Ausdehnungskoeffizienten des unteren/ersten Substrats bzw. der unteren/ersten Aufnahmeeinrichtung legen. In der besonders bevorzugten erfindungsgemäßen Ausführungsform eines Noppensubstrathalters kann das Substrat über die Raumbereiche zwischen den Noppen mit einem geheizten/gekühlten Gas in Kontakt gebracht werden. Um die Fixierfähigkeit der Fixierelemente aufrecht zu erhalten, muss der Druck des geheizten Gases kleiner sein als der Umgebungsdruck, welches das Substrat im Bereich der Zonen auf den Substrathalter drückt.

### Bonder

Eine erfindungsgemäße Vorrichtung besteht aus zwei erfindungsgemäßen Aufnahmeeinrichtungen/Substrathaltern. Vorzugsweise besitzt mindestens der obere Substrathalter Vermessungslöcher. Die Vermessungslöcher sind insbesondere verschließbar und/oder gedichtet ausgebildet.

Die erfindungsgemäßen Ausführungsformen werden mit Vorzug in einer definierten, insbesondere steuerbaren, Atmosphäre, insbesondere unter Normaldruck, betrieben.

Alle erwähnten erfindungsgemäßen Ausführungsformen können in einer speziellen Ausführungsvariante im Niedervakuum, mit größerem Vorzug im Hochvakuum, mit noch größerem Vorzug im Ultrahochvakuum betrieben werden, insbesondere bei einem Umgebungsdruck von weniger als 100 mbar, mit Vorzug weniger als 10⁻¹ mbar, mit größerem Vorzug weniger als 10⁻³ mbar, mit noch größerem Vorzug weniger als 10⁻⁵ mbar, mit allergrößtem Vorzug weniger als 10⁻⁸ mbar. Je höher das Vakuum bzw. je gering der der Druck in der Umgebung, desto schwieriger wird es allerdings, ein Substrat mit Hilfe von Vakuumlöchern zu fixieren und/oder erfindungsgemäß die Krümmung des Substrats einzustellen und/oder zu steuern.

### Prozesse

In einem ersten erfindungsgemäßen Prozessschritt eines ersten erfindungsgemäßen Prozesses werden ein erstes Substrat auf einen ersten Substrathalter und ein zweites Substrat auf einen zweiten Substrathalter geladen und insbesondere zumindest in einem Umfangsabschnitt fixiert.

Die Fixierung wird dabei insbesondere so durchgeführt, dass nur einige wenige, insbesondere weniger als 10, noch bevorzugter weniger als 5, am bevorzugtesten 3, am allerbevorzugtesten 2 Zonen eingeschalten werden. Die eingeschalteten Zonen sind insbesondere symmetrisch entlang eines Kreisrings verteilt.

In einem zweiten erfindungsgemäßen Prozessschritt eines ersten erfindungsgemäßen Prozesses werden die beiden Substrate zueinander ausgerichtet. Die Ausrichtung der Substrate wird hier nicht im Detail beschrieben. Insofern wir auf die Druckschriften US6214692B1, WO2015082020A1, WO2014202106A1 Bezug genommen. Die Substrate werden vor dem Bondvorgang insbesondere zueinander ausgerichtet, um Deckungsgleichheit (exakte Ausrichtung, insbesondere mit einer Genauigkeit von weniger als 2µm, vorzugsweise weniger als 250nm, noch bevorzugter weniger als 150nm, am bevorzugtesten weniger als 100nm, am allerbevorzugtesten kleiner als 50nm) korrespondierender Strukturen auf deren Oberflächen zu gewährleisten.

In einem dritten optionalen, erfindungsgemäßen Prozessschritt eines ersten erfindungsgemäßen Prozesses erfolgt die Annäherung der beiden Substrate durch eine Relativbewegung der beiden Substrathalter zueinander. Dadurch wird ein wohldefinierter Abstand (engl.: gap) zwischen den Substratoberflächen erzeugt. Denkbar ist auch, dass dieser Abstand schon vor dem oder während des Ausrichtungsprozesses eingestellt wird. Der Abstand beträgt insbesondere weniger als 1000µm, mit Vorzug weniger als 500µm, mit größerem Vorzug weniger als 250µm, mit allergrößtem Vorzug weniger als 100µm.

Erfindungsgemäß ist es besonders bevorzugt, wenn der Krümmungsradius der beiden Substrate, insbesondere an der Bondfront, um weniger als 15%, vorzugsweise weniger als 10%, noch bevorzugter weniger als 5%, noch bevorzugter weniger als 2% voneinander abweicht, am allerbevorzugtesten gleich ist.

In einem vierten erfindungsgemäßen Prozessschritt eines ersten erfindungsgemäßen Prozesses erfolgt eine Krümmung des ersten und/oder des zweiten Substrats. Gleichzeitig kann die Krümmung des ersten und/oder zweiten Substrats mit Hilfe der Sensoren vermessen und überwacht werden. Durch eine Regelschleife kann insbesondere eine gewollte Krümmung am unteren und/oder oberen Substrat automatisch eingestellt werden. Es wird ein Sollwert vorgegeben. Die Regelschleife steuert daraufhin die Fixierelemente und/oder das Verformungselement solange, bis das gewünschte Krümmungsprofil eingestellt wurde. Dabei ist zu erwähnen, dass die Gravitation in eine Richtung wirkt und sich daher unterschiedlich auf die Verformung der Substrate auswirken kann. Während ein oberes fixiertes Substrat durch die Gravitation weiter in Richtung des angestrebten Kontaktpunktes verformt wird, wirkt die Gravitation der Krümmung des unteren Substrats entgegen. Der Einfluss der Gravitation kann allerdings auch vernachlässigbar klein sein. Durch die erfindungsgemäße Verwendung von automatisch gesteuerten oder geregelten Krümmungsmitteln oder Krümmungsänderungsmitteln, Fixierelementen und Sensoren kann für jedes der beiden Substrate, insbesondere als Teil einer Regelschleife, das gewünschte Krümmungsprofil eingestellt werden. Sind die beiden Substrate nahe genug aneinander angenähert worden, erfolgt die Kontaktierung der beiden Substrate. Die Kontaktierung kann entweder durch die stetig steigende Krümmung erfolgen und/oder durch eine relative Annäherung der beiden Substrathalter zueinander. Bei dem erfindungsgemäßen Bondverfahren werden die Substrate also nicht plan aufeinandergelegt, sondern zunächst in der Mitte M miteinander in Kontakt gebracht (Bondinitiierungsstelle), indem eines der beiden gekrümmten Substrate leicht gegen das zweite Substrat gedrückt wird beziehungsweise entsprechend in Richtung des gegenüberliegenden Substrates verformt wird. Nach dem Loslösen des verformten (in Richtung des gegenüberliegenden Substrats) durchgebogenen Substrats erfolgt durch das Voranschreiten einer Bondwelle ein kontinuierliches und gleichmäßigeres, mit minimalster Kraft und damit mit minimalsten, vorwiegend horizontalen, Verzerrungen verbundenes, insbesondere zumindest teilweise, vorzugsweise überwiegend, selbsttätiges Bonden entlang der Bondfront.

Insbesondere können die Zonen so ein- bzw. ausgeschalten werden, dass sich eine Abweichung der symmetrischen Durchbiegung eines Substrats ergibt. Insbesondere nimmt die Symmetrie der Durchbiegung ab. Denkbar ist, dass beim Ausschalten von mehreren Zonen Durchbiegungen des Substrats erfolgen, welche eine
- lineare bzw. uniaxiale
- n-förmige, insbesondere
   ∘ dreieckige
   ∘ quadratische
   ∘ fünfeckige
   ∘ sechseckige
   ∘ siebeneckige
   ∘ achteckige
   ∘ sternförmige

Symmetrie aufweisen. Die Symmetrie der Durchbiegung kann so eingestellt werden, dass beim Voranschreiten der Bondwelle ein möglichst minimaler "run-out" entsteht.

In einem fünften erfindungsgemäßen Prozessschritt eines ersten erfindungsgemäßen Prozesses erfolgt das Voranschreiten, die Überwachung und die Steuerung der Bondwelle. Soweit die Bondinitiierungsstelle im Zentrum der Kontaktflächen der Substrate angeordnet wird und nur zwei Zonen, die sich in Bezug zum Zentrum gegenüberliegen, zur Fixierung dienen, ist ein gleichmäßiger, insbesondere linearer Verlauf der Bondwelle realisierbar. Im idealsten Fall existieren genau zwei Bondwellen, eine für jede Seite.

Besonders vorteilhaft ist es, wenn die Verformung, vorzugsweise Krümmung, des ersten und/oder zweiten Substrats und/oder des zweiten Substrats konvex und/oder konkav erfolgt, noch bevorzugter spiegelsymmetrisch. Mit anderen Worten folgt die Verformung erfindungsgemäß insbesondere durch Dehnung und/oder Stauchung und/oder Krümmung des ersten Substrats und/oder des zweiten Substrats.

Bevorzugt weisen die Substrate annähernd identische Durchmesser D1, D2 auf, die insbesondere um weniger als 5 mm, vorzugsweise weniger als 3 mm, noch bevorzugter weniger als 1 mm, voneinander abweichen.

Gemäß einem weiteren, insbesondere eigenständigen, Erfindungsaspekt erfolgt die Verformung, vorzugsweise Krümmung, durch Verformungsmittel oder Krümmungsmittel und/oder Krümmungsänderungsmittel und/oder durch Temperatursteuerung der ersten und/oder zweiten Aufnahmeeinrichtungen.

In einem weiteren eigenständigen, Erfindungsaspekt kann die Aufnahmeeinrichtung selbst krümmbar konstruiert sein, ähnlich die Ausführungsformen in den Druckschriften
WO2014191033 A1, WO2016093284 A1, und US7682933 B1

Indem das erste Substrat und/oder das zweite Substrat ausschließlich im Bereich der Peripherie oder des Umfangs des ersten und/oder zweiten Substrathalters oder der ersten und/oder zweiten Substrate fixiert wird, ist die erfindungsgemäße Verformung/Krümmung/Krümmungsänderung leichter realisierbar.

Die Fixierung erfolgt über die Zonen, die den Bedingungen entsprechend geschalten werden, um die gewünschte Symmetrie der Durchbiegung zu erhalten, welche den "run-out" Fehler, insbesondere an jeder Position der miteinander verbondeten Substrate, minimiert.

Die Steuerung der vorbeschriebenen Schritte und/oder Bewegungen und/oder Abläufe, insbesondere der Verformungsmittel oder Krümmungsmittel und/oder Krümmungsänderungsmittel und/oder Fixiermittel, die Annäherung der Substrate zueinander, die Temperatur-, Druck- und Gaszusammensetzungskontrolle, erfolgt mit Vorzug über eine zentrale Steuereinheit, insbesondere einen Computer mit einer Steuerungssoftware. Zur Steuerung und oder Regelung werden die oben beschriebenen Sensoren verwendet.

Mit Vorzug werden die Substrate ausschließlich an einem möglichst weit außenliegenden Kreissegment im Bereich des Seitenrandes fixiert, um den Substraten möglichst große Flexibilität und Dehnungsfreiheit innerhalb der Fixierung zu gewähren.

Das erste und/oder zweite Substrat ist mit Vorzug radialsymmetrisch. Obwohl das Substrat jeden beliebigen Durchmesser besitzen kann, ist der Substratdurchmesser insbesondere 1 Zoll, 2 Zoll, 3 Zoll, 4 Zoll, 5 Zoll, 6 Zoll, 8 Zoll, 12, Zoll, 18 Zoll oder größer als 18 Zoll. Die Dicke des ersten und/oder zweiten Substrats liegt zwischen 1µm und 2000µm, mit Vorzug zwischen 10µm und 1500µm, mit größerem Vorzug zwischen 100µm und 1000µm.

In besonderen Ausführungsformen kann ein Substrat auch eine rechteckige, oder zumindest von der kreisförmigen Gestalt abweichende, Form besitzen. Als Substrate werden vorzugsweise Wafer verwendet.

Mit besonderem Vorzug werden alle veränderbaren Parameter so gewählt, dass die Bondwelle sich mit einer möglichst optimalen Geschwindigkeit bezüglich der vorhandenen Anfangs- und Randbedingungen ausbreitet. Vor allem bei vorhandener Atmosphäre, insbesondere Normaldruck, ist eine möglichst langsame Geschwindigkeit der Bondwelle vorteilhaft. Die mittlere Geschwindigkeit der Bondwelle ist insbesondere geringer als 200 cm/s, mit größerem Vorzug geringer als 100 cm/s, mit größerem Vorzug geringer als 50 cm/s, mit größtem Vorzug geringer als 10 cm/s, mit allergrößtem Vorzug geringer als 1 cm/s. Insbesondere ist die Geschwindigkeit der Bondwelle größer als 0,1 cm/s. Insbesondere ist die Geschwindigkeit der Bondwelle entlang der Bondfront konstant. In einer Vakuumumgebung wird die Geschwindigkeit der Bondwelle automatisch schneller, da die sich entlang der Bondlinie verbindenden Substrate keinen Widerstand durch ein Gas überwinden müssen.

Ein weiterer, insbesondere eigenständiger, Erfindungsaspekt besteht darin, möglichst koordiniert und gleichzeitig quasi-selbsttätig zu kontaktieren, indem zumindest eines der Substrate mit einer, insbesondere konzentrisch zur Mitte M einer Kontaktfläche des Substrats radial nach außen verlaufenden, Vorspannung vor dem Kontaktieren beaufschlagt wird und dann nur der Beginn des Kontaktierens beeinflusst wird, während nach Kontaktierung eines Abschnitts, insbesondere der Mitte M des Substrats, das Substrat freigelassen wird und selbsttätig auf Grund seiner Vorspannung kontrolliert mit dem gegenüberliegenden Substrat bondet. Die Vorspannung wird durch eine Verformung, insbesondere Krümmung, des ersten Substrats durch Verformungsmittel, insbesondere Krümmungsmittel und/oder Krümmungsänderungsmittel, erreicht, wobei die Verformungsmittel, insbesondere auf Grund ihrer Form, auf die von der Bondseite abgewandte Seite einwirken und die Verformung entsprechend durch Einsatz unterschiedlicher (insbesondere austauschbarer) Verformungsmittel steuerbar ist. Die Steuerung erfolgt auch durch den Druck oder die Kraft, mit der Die Verformungselemente auf das Substrat wirken. Vorteilhaft ist es dabei, die wirksame Aufnahmefläche der Substrathalterung mit dem Substrat zu reduzieren, so dass das Substrat nur teilweise von der Aufnahmeeinrichtung gestützt wird. Auf diese Weise ergibt sich durch die kleinere Kontaktfläche eine geringere Adhäsion zwischen dem Substrat und der Substrathalterung. Eine Fixierung wird erfindungsgemäß, insbesondere, im Bereich des Umfangs des Substrats angelegt, so dass eine effektive Fixierung gegeben ist bei gleichzeitig geringstmöglicher wirksamer Aufnahmefläche zwischen der Aufnahmekontur der Substrathalterung und dem Substrat. Somit ist gleichzeitig ein schonendes und sicheres Ablösen des Substrats möglich, da die zum Ablösen des Substrats notwendigen Lösekräfte so gering wie möglich sind. Das Ablösen ist vor allem kontrollierbar, insbesondere durch Reduzierung des Unterdrucks an der Aufnahmefläche. Kontrollierbar bedeutet, dass nach dem Kontakt des Substrats mit einem zweiten Substrat, das Substrats am Probenhalter noch fixiert bleibt und erst durch gezielte (gesteuerte) Reduzierung des Unterdrucks an der Aufnahmefläche ein Loslösen des Substrats (Wafers) vom Probenhalter (Aufnahmeeinrichtung), insbesondere von innen nach außen, bewirkt wird. Die erfindungsgemäße Ausführungsform führt vor allem dazu, dass das Ablösen durch sehr geringe Kräfte bewerkstelligt werden kann. Im speziellen werden mehrere, unterschiedliche Methoden des Loslösens offenbart.
- Vollständiges, plötzliches Loslösen des Substrats, während das Verformungsmittel inaktiv ist,
- Vollständiges, plötzliches Loslösen des Substrats, während das Verformungsmittel spontan in seinen Ausgangszustand gestellt wird und damit sofort aufhört auf das Substrat zu wirken,
- Vollständiges, plötzliches Loslösen des Substrats, während das Verformungsmittel schrittweise aber kontinuierlich aufhört auf das Substrat zu wirken,
- Schrittweises, insbesondere Zone für Zone bezogenes, vorzugsweise von Innen- nach Außen durchgeführtes Loslösen des Substrates, durch schrittweises Abschalten der Fixierungen, während das Verformungsmittel auf das Substrat einwirkt,
- Eine Kombination der genannten Methoden

Die erfindungsgemäße Ausführungsform offenbart in Ihrer optimalen Form einen Bondvorgang, bei dem beide Substrate gekrümmt sind. Im Allgemeinen kann aber mindestens ein Substrat auch nicht verformt werden. In Kombination mit den genannten Loslösemechanismen, ergibt sich folgende Tabelle:

| Beispiel # | Oben verformt | Unten verformt | Oben Loslösen | Unten Loslösen |
|---|---|---|---|---|
| 1 | Nein | Ja | Nein | Ja |
| 2 | Nein | Ja | Ja | Nein |
| 3 | Ja | Ja | Nein | Ja |
| 4 | Ja | Ja | Ja | Nein |
| 5 | Ja | Nein | Nein | Ja |
| 6 | Ja | Nein | Ja | Nein |

Alle Strukturen auf den Substraten können bereits so designt, berechnet und erzeugt werden, dass die erfindungsgemäßen Verfahren und Anlagen einen optimale Kompensation des "run-out" Fehlers erzeugen. Es ist beispielsweise denkbar, dass rechteckige Strukturen in jene Richtung um einen Faktor kleiner designt werden um den der "run-out" Fehler die Struktur verzerrt. Dieser Faktor liegt insbesondere zwischen 0 und 3, vorzugsweis zwischen 0 und 2, noch bevorzugter zwischen 0 und 1, am bevorzugtesten zwischen 0 und 0.1, am allerbevorzugtesten zwischen 0 und 0.001. Ist auf Messungen und/oder Berechnungen beispielsweise bekannt, dass ein "run-out" Fehler an einer definierten Position der Substrate zu einer Verzerrung um den Faktor 1.021 in x-Richtung führt, so wird die Struktur in x-Richtung mit demselben Faktor im Computer vergrößert. Ein Faktor von 1 würde eine Dimension der Struktur daher unverzerrt belassen. Ein Faktor kleiner als 1 würde die Struktur in vorgegebener Dimension verkleinern, ein Faktor größer als 1 entsprechend vergrößern. Wird die Struktur danach hergestellt ist sie um diesen Faktor in x-Richtung größer.

Anstatt der Verwendung von multiplikativen Faktoren können auch positive und negative Summanden verwendet werden um durch Addition bzw. Subtraktion die Änderung der Dimension einer Richtung der Struktur anzugeben. Auf die Angabe von Wertebereichen wird hierbei verzichtet.

Denkbar ist auch, dass die Strukturen im Computer im Normalzustand designed werden, aber die Herstellungsgeräte wie beispielsweise Lithographieanlagen die Strukturen entsprechend der vorher berechneten und/oder ermittelten Faktoren skaliert herstellen. Als Herstellungsgeräte werden insbesondere genannte
∘ Lithographieanlage, insbesondere
   ▪ Photolithographische Anlage, insbesondere
      - Stepper
   ▪ Imprintlithographische Anlage
      - Stepper
   ▪ Strahlungslithographieanlage, insbesondere
      - Elektronenstrahllithographie
      - Ionenstrahllithographie
      - Laserlithographie

Die erfindungsgemäßen Methoden und Anlagen in Verbindung mit einem korrekten Design- und/oder Berechnungs- und/oder Herstellvorgang der zu verbondenden Strukturen führt daher zu einer weiteren und optimierteren Bondqualität und damit zu noch besseren Ergebnissen. Wenn also ein auftretender "run-out" Fehler berechenbar oder messbar ist, der sich durch die Beeinflussung der Bondwelle durch erfindungsgemäße Verfahren und/oder Anlagen nicht mehr weiter reduzieren lässt, dann kann die obige Methode zu dessen weiterer Reduktion genutzt werden.

Vorrichtungsgemäß offenbarte Merkmale sollen auch als verfahrensgemäß offenbart gelten und umgekehrt.

Weitere Vorteile, Merkmale und Einzelheiten der Erfindung ergeben sich aus der nachfolgenden Beschreibung bevorzugter Ausführungsbeispiele sowie anhand der Zeichnungen. Die zeigen in:
- Figur 1a: eine schematische, nicht maßstabsgetreue Teilansicht einer ersten Ausführungsform einer erfindungsgemäßen Aufnahmeeinrichtung,
- Figur 1b: eine schematische, nicht maßstabsgetreue Teilansicht einer zweiten Ausführungsform der erfindungsgemäßen Aufnahmeeinrichtung,
- Figur 1c: eine schematische, nicht maßstabsgetreue Teilansicht einer dritten Ausführungsform der erfindungsgemäßen Aufnahmeeinrichtung,
- Figur 1d: eine schematische, nicht maßstabsgetreue Teilansicht einer vierten Ausführungsform der erfindungsgemäßen Aufnahmeeinrichtung,
- Figur 1e: eine schematische, nicht maßstabsgetreue Teilansicht einer ersten Ausführungsform eines Krümmungs(änderungs)mittels der erfindungsgemäßen Aufnahmeeinrichtung,
- Figur 1f: eine schematische, nicht maßstabsgetreue Teilansicht einer zweiten Ausführungsform eines Krümmungs(änderungs)mittels der erfindungsgemäßen Aufnahmeeinrichtung,
- Figur 2a: eine schematische, nicht maßstabsgetreue Aufsicht einer fünften Ausführungsform einer erfindungsgemäßen Aufnahmeeinrichtung,
- Figur 2b: eine schematische, nicht maßstabsgetreue Aufsicht einer sechsten Ausführungsform einer erfindungsgemäßen Aufnahmeeinrichtung,
- Figur 2c: eine schematische, nicht maßstabsgetreue Aufsicht einer siebten Ausführungsform einer erfindungsgemäßen Aufnahmeeinrichtung,
- Figur 2d: eine schematische, nicht maßstabsgetreue Aufsicht einer achten Ausführungsform einer erfindungsgemäßen Aufnahmeeinrichtung,
- Figur 2e: eine schematische, nicht maßstabsgetreue Aufsicht einer neunten Ausführungsform einer erfindungsgemäßen Aufnahmeeinrichtung,
- Figuren 3a-3e: schematische, nicht maßstabsgetreue Seitenansichten und Aufsichten von Ausführungsformen einer erfindungsgemäßen Erhebung,
- Figur 4a: eine schematische, nicht maßstabsgetreue Querschnittsansicht einer Ausführungsform eines erfindungsgemäßen Bonders mit Druck- und Abstandsdiagrammen in einem ersten Verfahrensschritt eines erfindungsgemäßen Verfahrens,
- Figur 4b: eine schematische, nicht maßstabsgetreue Querschnittsansicht der Ausführungsform gemäß Figur 4a in einem weiteren Verfahrensschritt,
- Figur 4c: eine schematische, nicht maßstabsgetreue Querschnittsansicht der Ausführungsform gemäß Figur 4a in einem weiteren Verfahrensschritt,
- Figur 4d: eine schematische, nicht maßstabsgetreue Querschnittsansicht der Ausführungsform gemäß Figur 4a in einem weiteren Verfahrensschritt und
- Figur 4e: eine schematische, nicht maßstabsgetreue Querschnittsansicht der Ausführungsform gemäß Figur 4a in einem weiteren Verfahrensschritt,
- Figur 5a: eine schematische Unteransicht eines oberen Probenhalters in einer ersten Fixierkonfiguration,
- Figur 5b: eine andere schematische Unteransicht des oberen Probenhalters in einer zweiten Fixierkonfiguration,
- Figur 6a: eine schematische Oberansicht zweier Strukturen in einer nicht idealen Ausrichtung,
- Figur 6b: eine schematische Oberansicht zweier Strukturen in einer idealeren Ausrichtung,
- Figur 7a: eine schematische Oberansicht zweier Substrate mit einem ersten Vektorfeld und
- Figur 7b: eine schematische Oberansicht zweier Substrate mit einem zweiten Vektorfeld.

In den Figuren sind gleiche Bauteile und Bauteile mit der gleichen Funktion mit den gleichen Bezugszeichen gekennzeichnet.

Die X-Achse verläuft in der Aufnahmefläche 1s, 1s', 1s", 1s'" des Substrathalters 1o bzw. 1u. Die Y-Achse verläuft senkrecht zur X-Achse und ebenfalls in der Aufnahmefläche 1s, 1s', 1s", 1s'" des Substrathalters 1o bzw. 1u. Die Z-Achse verläuft senkrecht zur X- und Y-Achse sowie senkrecht zur Aufnahmefläche 1s, 1s', 1s", 1s'" des Substrathalters 1o bzw. 1u.

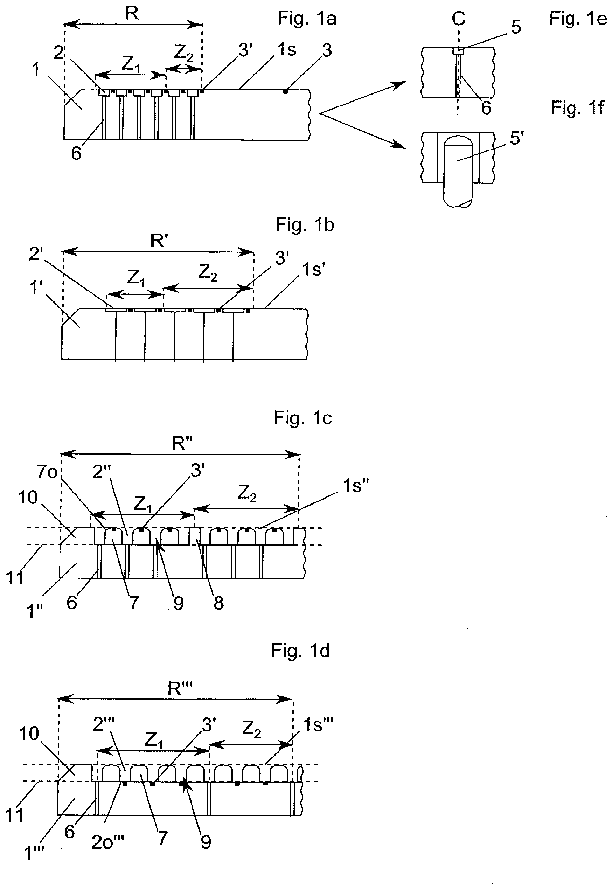

Die Figur 1a zeigt eine schematische, nicht maßstabsgetreue, Teilansicht eines Querschnitts einer ersten Ausführungsform einer erfindungsgemäßen Aufnahmeeinrichtung 1 (alternativ als Substrathalter bezeichnet), wobei nur ein Randbereich R mit Fixierelementen 2 (Fixiermittel) dargestellt ist.

Die Aufnahmeeinrichtung 1 besteht aus mehreren Zonen Zi, die sich vorzugsweise im Randbereich R befinden. Jede der Zonen Zi kann mehrere Fixierelemente 2 besitzen. In der Figur 1a werden beispielhaft zwei Zonen Z1 und Z2 dargestellt. In der ersten Zone Z1 sind vier Fixierelemente 2 im Querschnitt gezeigt, während in der zweiten Zone Z2 zwei Fixierelemente 2 gezeigt sind. Insbesondere können sich die Zonen Zi auf den Randbereich R des Substrathalters 1 beschränken oder über den gesamten Substrathalter 1 verteilt sein.

Die Fixierelemente 2 dienen zur Fixierung einer Substrataufnahmefläche 4a eines ersten, insbesondere oberen, Substrats 1o oder eines zweiten, insbesondere unteren, Substrats 1u.

Vorzugsweise befinden sich mehrere Sensoren 3, 3', insbesondere Abstandssensoren in der Aufnahmefläche 1s. Die Sensoren dienen der Vermessung physikalischer und/oder chemischer Eigenschaften zwischen dem fixierten Substrat 4 und der Aufnahmefläche 1s. Bei den Sensoren 3, 3' handelt es sich insbesondere um Abstandssensoren, mit deren Hilfe ein Abstand zwischen der Aufnahmefläche 1s und der Substrataufnahmefläche 4a gemessen wird.

Der Substrathalter 1 ist vorzugsweise so konstruiert, dass sich in seinem Zentrum C (siehe Figur 1e und 1f) ein Krümmungselement 5, 5' (Krümmungsmittel) befindet, mit dessen Hilfe ein am Substrathalter 1 fixiertes Substrat 4o, 4u gekrümmt werden kann. Mit besonderem Vorzug handelt es sich bei dem Krümmungselement 5 um eine Fluidaustrittsöffnung, über die ein Gas, insbesondere Druckluft, zwischen den Substrathalter 1 und das Substrat 4 gepumpt werden kann. Durch den Überdruck wird das Substrat 4 gewölbt, während es gleichzeitig von den Fixierelementen 2 fixiert oder kontrolliert losgelassen wird.

In der alternativen erfindungsgemäßen Ausführungsform gemäß Figur 1f ist das Krümmungselement 5' ein Stift (engl.: pin), der sich durch die Aufnahmeeinrichtung 1 erstreckt und der senkrecht zu dieser verfahrbar ausgebildet ist (Krümmungsmittel oder Krümmungsänderungsmittel).

Die Ausführungen zu den Figuren 1e und 1f gelten analog für die Ausführungsformen gemäß Figuren 1a bis 1d.

In Figur 1b ist ein Substrathalter 1' in einer zweiten erfindungsgemäßen Ausführungsform gezeigt. Der Substrathalter 1' besteht aus mehreren Zonen Zi die sich vorzugsweise im Randbereich R befinden. Jede der Zonen Zi kann im Allgemeinen mehrere Fixierelemente 2' besitzen. Bei den Fixierelementen 2' handelt es sich um Elektroden einer elektrostatischen Fixierung. In der Figur 1b werden beispielhaft zwei Zonen Z1 und Z2 dargestellt. In der ersten Zone Z1 erkennt man zwei Fixierelemente 2' im Querschnitt, in der zweiten Zone Z2 sind drei Fixierelemente 2' im Querschnitt erkennbar. Insbesondere können sich die Zonen Zi auf den äußeren Rand des Substrathalters 1' beschränken, oder über den gesamten Substrathalter 1' verteilt sein.

Vorzugsweise befinden sich mehrere Sensoren 3, 3', insbesondere Abstandssensoren, in der Aufnahmefläche 1s'. Die Sensoren 3, 3' dienen der Vermessung physikalischer und/oder chemischer Eigenschaften zwischen dem fixierten Substrat 4 und der Aufnahmefläche 1s'. Bei den Sensoren 3, 3' handelt es sich insbesondere um Abstandssensoren, mit deren Hilfe der Abstand zwischen der Aufnahmefläche 1s' und der Substrataufnahmefläche 4a vermessen wird.

In Figur 1c ist ein Substrathalter 1" in einer dritten erfindungsgemäßen Ausführungsform offenbart. Der Substrathalter 1" besteht aus mehreren Zonen Zi, die sich vorzugsweise ausschließlich im Randbereich R befinden. Jede der Zonen Zi kann insbesondere mehrere Fixierelemente 2" besitzen.

Die Fixierelemente 2" sind Raumbereiche 9 zwischen der Substrataufnahmefläche la, benachbarten Stegen 8 oder einem Randelement 10 und Stegen 8 und einem von Leitungen 6 durchsetzten Boden. In den Leitungen 6 wird ein Druck eingestellt, um das Substrat 4o, 4u anzusaugen und somit zu fixieren.

In dem Raumbereich 9 befinden sich insbesondere mehrere Noppen 7, auf welchen das Substrat 4o, 4u aufliegt. Die Noppen 7 dienen insbesondere der Vermeidung einer zu großen Kontamination. Die Noppen 7 wurden in der Figur 1c überdurchschnittlich groß dargestellt, um die Ansicht zu verbessern. In Wirklichkeit sind die Noppen 7 im Vergleich zur Dicke des Substrathalters 1" wesentlich kleiner.

In der Figur 1c werden beispielhaft zwei Zonen Z1 und Z2 dargestellt. In der ersten Zone Z1 erkennt man drei Fixierelemente 2" im Querschnitt, in der zweiten Zone Z2 sind ebenfalls drei Fixierelemente 2" im Querschnitt erkennbar. Insbesondere können sich die Zonen Zi auf den äußeren Rand des Substrathalters 1" beschränken oder über den gesamten Substrathalter 1" verteilt sein.

Vorzugsweise befinden sich mehrere Sensoren 3, 3', insbesondere Abstandssensoren, in den Noppen 7, insbesondere an einer Noppenoberfläche 7o der Noppen 7, welche die Substrataufnahmefläche 1a im nicht gekrümmten Zustand kontaktiert. Die Sensoren dienen der Vermessung physikalischer und/oder chemischer Eigenschaften zwischen dem fixierten Substrat 4 und der durch die Noppenoberfläche 7o und das umlaufende Randelement 10 definierte Aufnahmefläche 1s'. Bei den Sensoren 3, 3' handelt es sich insbesondere um Abstandssensoren, mit deren Hilfe der Abstand zwischen der Noppenoberfläche 7o und der Substratoberfläche 4o vermessen wird.

In Figur 1d ist ein Substrathalter 1'" in einer vierten erfindungsgemäßen Ausführungsform gezeigt. Der Substrathalter 1'" besteht insbesondere aus mehreren Zonen Zi die sich vorzugsweise im Randbereich R befinden. Jede der Zonen Zi kann mehrere Fixierelemente 2'" besitzen.

Bei den Fixierelementen 2'" handelt es sich um die Raumbereiche 9 zwischen zwei benachbarten Leitungen 6, in denen ein Druck eingestellt werden kann. Eine Begrenzung der Raumbereiche 9 findet nur am Umfang der Aufnahmeeinrichtung 1''' durch ein umlaufendes Randelement 10 statt, auf dem das Substrat 1o, 1u umfänglich aufliegt und das gemeinsam mit der Noppenoberfläche 7o eine Aufnahmefläche 1s" definiert.

In dem Raumbereich 9 befinden sich insbesondere mehrere Noppen 7, auf deren Noppenoberfläche 7o ein Substrat 4o, 4u aufgenommen werden kann. Die Noppen 7 dienen insbesondere der Vermeidung einer zu großen Kontamination. Die Noppen 7 wurden in der Figur 1c überdurchschnittlich groß dargestellt, um die Ansicht zu verbessern. In Wirklichkeit sind die Noppen im Vergleich zur Dicke des Substrathalters 1'" wesentlich kleiner.

In der Figur 1d werden beispielhaft zwei Zonen Z1 und Z2 dargestellt. In der ersten Zone Z1 erkennt man ein Fixierelement 2'" im Querschnitt, in der zweiten Zone Z2 ist ebenfalls ein Fixierelement 2'" im Querschnitt vorhanden. Insbesondere können sich die Zonen Zi auf den äußeren Rand des Substrathalters 1''' beschränken oder über den gesamten Substrathalter 1''' verteilt sein.

Vorzugsweise befinden sich mehrere Sensoren 3, 3', insbesondere Abstandssensoren, auf einem Boden der Raumbereiche 9 zwischen den Noppen 7. Die Sensoren 3, 3' dienen der Vermessung physikalischer und/oder chemischer Eigenschaften zwischen dem fixierten Substrat 4 und dem Boden. Bei den Sensoren 3, 3' handelt es sich insbesondere um Abstandssensoren, mit deren Hilfe der Abstand zwischen dem Boden und der Substrataufnahmefläche 4a vermessen wird. Hieraus lässt sich über die bekannte Höhe der Noppen 7, der Abstand der Substrataufnahmefläche 1a zu der Noppenoberfläche 7o berechnen.

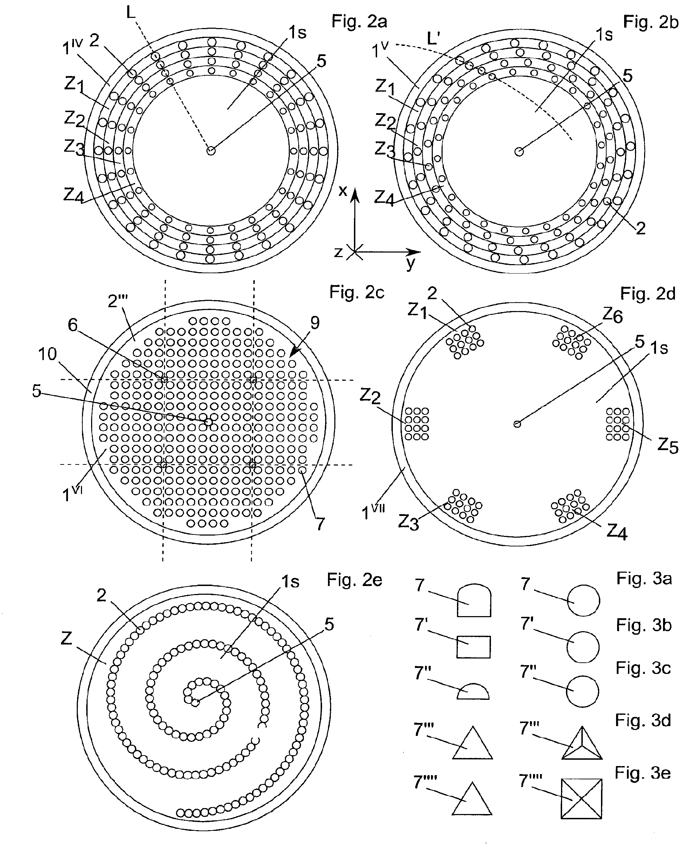

Die Figur 2a zeigt eine Aufnahmeeinrichtung 1^{IV}, bei der Fixierelemente 2 in vier konzentrischen Zonen Z1-Z4 angeordnet sind. Im Zentrum C der Aufnahmeeinrichtung 1^{IV} befindet sich ein Krümmungselement 5, 5' (siehe Figur le oder 1f). Korrespondierende Fixierelemente 2 mehrerer Zonen sind jeweils entlang radial verlaufender Linien L angeordnet.

Die Figur 2b zeigt eine Aufnahmeeinrichtung 1^{V}, bei der Fixierelemente 2 in vier Zonen Z1-Z4 angeordnet sind. Im Zentrum der Aufnahmeeinrichtung 1^{V} befindet sich ein Krümmungselement 5, 5" (siehe Figur 1e oder 1f). Korrespondierende Fixierelemente 2 mehrerer Zonen sind jeweils entlang einer Linie L' angeordnet, die nicht durch das Krümmungselement 5, insbesondere nicht durch das Zentrum C, verläuft. Die Linie L' muss insbesondere keine Gerade sein. Jeweils gegenüberliegende, korrespondierende, Fixierelemente 2 sind punktgespiegelt zum Zentrum C angeordnet.

Die Figur 2c zeigt eine Aufnahmeeinrichtung 1^{VI} mit mehreren Noppen 7, umgeben von einem Randelement 10 analog der Ausführungsform gemäß Figur 1c. Zwischen den Noppen 7 befinden sich die Raumbereiche 9, die bei einer Evakuierung als Fixierelemente 2^{IV} wirken. Die Evakuierung erfolgt über Leitungen 6. Da bei dieser erfindungsgemäßen Ausführungsform keine Stege 8 vorhanden sind, welche die Raumbereiche 9 voneinander abtrennen, wird ein über ein Krümmungselement 5 (siehe Figur le) eingebrachtes Fluid direkt über die Kanäle 6 wieder abgesaugt werden. Daher ist diese erfindungsgemäße Ausführungsform ein Beispiel für einen Substrathalter, bei dem eine stationäre laminare Strömung zwischen dem Substrathalter 1^{VI} und dem Substrat 4o, 4u aufgebaut wird.

Die Figur 2d zeigt eine erfindungsgemäße Ausführungsform, bei der mehrere Zonen Z mit mehreren Fixierelementen 2 versehen sind. Die Zonen Z befinden sich an der Peripherie des Probenhalters 1VII und können ein Substrat 4 an maximal 6 Position fixieren. Durch die Fixierung eines Substrats 4o über die Zonen Z1, Z3 und Z5 kann ein Substrat beispielsweise durch die Gravitation eine mehr oder weniger dreieckige Durchbiegung erfahren. Analoge Überlegungen gelten für das Schalten von Zonen in Viereckiger oder anderer Anordnung.

Die Figur 2e zeigt eine erfindungsgemäße Ausführungsform, bei der die Fixierelemente 2 entlang einer Spirale angeordnet sind. In diesem Fall stellt die gesamte Aufnahmefläche 1s die einzige Zone Z dar. Denkbar ist die einzelne oder gruppierte Ansteuerung der Fixierelemente. Am Ende der Spirale und im Zentrum C ist das Krümmungselement 5, 5' angeordnet.

Alle Ausführungsformen gemäß den Figuren 2a-2e sind Aufnahmeeinrichtungen, bei denen die Fixierungen als Unterdruck- oder Vakuumfixierungen ausgeführt wurden. Analog können entsprechende Substrathalter mit elektrostatischer Fixierung realisiert werden. Die Sensoren 3, 3' wurden der Übersichtlichkeit halber nicht dargestellt, können aber entsprechend den Ausführungsformen gemäß Figuren 1a bis 1d ausgeführt werden.

Die Figuren 3a-3e zeigen Ausführungsbeispiele für Formen der Erhebungen 7, 7', 7", 7''', 7''''. Die Form gemäß Figur 3a besteht aus einem zylindrischen Grundkörper mit rundem Kopf. Die Form gemäß Figur 3b besteht aus einem zylindrischen Grundkörper mit flachem Kopf. Die Form gemäß Figur 3c besteht aus einem halbkugelförmigen Grundkörper. Die Form gemäß Figur 3d besteht aus einer dreiseitigen Pyramide. Die Form gemäß Figur 3e besteht aus einer vierseitigen Pyramide.

In den folgenden Figurenbeschreibungen wird ein erfindungsgemäßer Bondvorgang exemplarisch dargestellt, bei dem eine uniaxiale Krümmung des Substrats 4o und 4u mit Hilfe eines Krümmungsmittels 5 erfolgt.

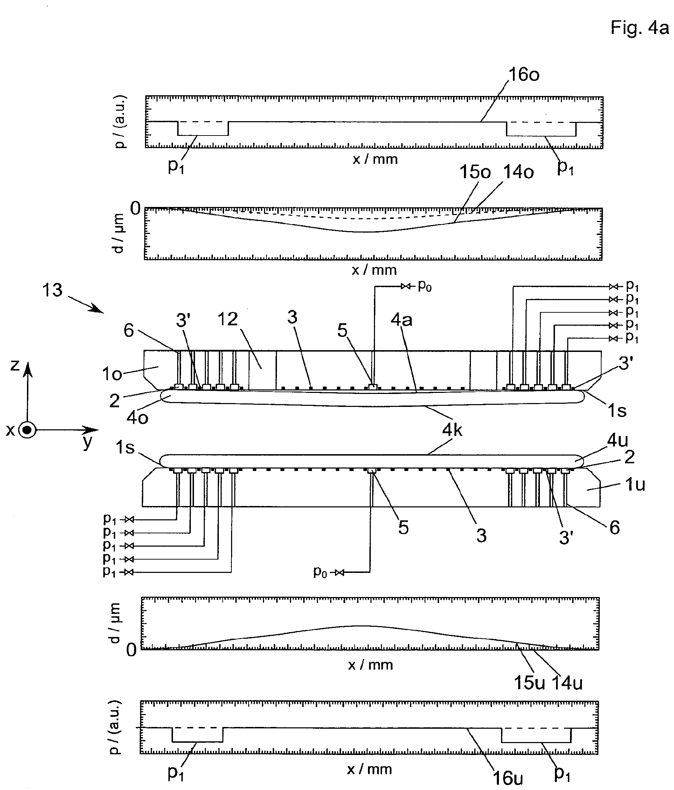

Die Figur 4a zeigt einen erfindungsgemäßes Bonder 13 zur Kontaktierung und zum Bonden von gegenüberliegend angeordneten Kontaktflächen 4k eines ersten/oberen Substrats 4o und eines zweiten/unteren Substrats 4u. Der Bonder 13 besteht aus einem unteren Substrathalter 1u und einem oberen Substrathalter 1o. Die Substrathalter 1u, 1o können insbesondere als oben beschriebene Aufnahmeeinrichtungen 1, 1', 1", 1", 1^{IV}, I^{V}, 1^{VI} zur Aufnahme eines ersten/oberen Substrats 4o und eines zweiten/unteren Substrats 4u ausgeführt sein, wobei der untere Substrathalter 1u anders als der obere Substrathalter 1o ausgeführt oder ausgestattet sein kann.

Der obere Substrathalter 1o weist vorzugsweise Vermessungslöcher 12 auf, durch welche hindurch von einer Rückseite des Substrathalters 1o eine Vermessung des Substrats 4o stattfinden kann. Alternativ können Sensoren in den Vermessungslöchern angeordnet werden. Die Vermessungslöcher 12 sind insbesondere zwischen den Krümmungsänderungsmitteln und den Fixiermitteln angeordnet. Alternativ oder zusätzlich kann der untere Substrathalter 1u entsprechende Vermessungslöcher 12 aufweisen. Die Vermessungslöcher durchsetzen die Aufnahmeeinrichtung 1 und verlaufen insbesondere orthogonal zur Aufnahmefläche 1s. Vorzugsweise sind die Vermessungslöcher 12 in einem Abstand von 180° oder 120° zueinander angeordnet.

Die Substrathalter 1u, 1o besitzen eine Aufnahmefläche 1s, mit mehreren Fixierelementen 2 und Sensoren 3, 3'. Die Fixierelemente 2 werden über Leitungen 6 evakuiert und fixieren die Substrate 4u, 4o. Unter- und oberhalb der Substrathalter 1u, 1o sind Diagramme eingezeichnet, welche jeweils Abstände d zwischen den als Abstandssensoren ausgeführten Sensoren 3 und dem Substrat 4u, 4o entlang der x-Richtung (Substratdurchmesser) für die jeweiligen x-Positionen zeigen. Die Abstandssensoren sind direkt am Krümmungsänderungsmittel 5 bis zu den Fixiermitteln verteilt angeordnet. Sie erstrecken sich somit über eine Teilfläche der Aufnahmefläche 1s.

Im Bereich der Fixiermittel sind als Drucksensoren ausgebildete Sensoren 3' angeordnet, mit welchen entlang der x-Position der Sensoren 3' zwischen den Substraten 4u, 4o und den Substrathaltern 1u, 1o die Drücke p₁ gemessen werden.

In den Abstandsdiagrammen sind angestrebte, insbesondere durch eine Software eingestellte, Soll-Krümmungen 15u, 15o, sowie die von den Abstandssensoren gemessenen Ist-Krümmungen 14u, 14o eingezeichnet. Das obere Substrat 4o weist eine, insbesondere auf Grund der Gravitation vorhandene, Ist-krümmung 14o auf, während das untere Substrat 1u plan aufliegt und daher im Sinne der vorliegenden Erfindung keine (in Realität eine verschwindend geringe) Ist-Krümmung 14u besitzt. Denkbar ist allerdings auch, dass die gravitativ eingestellte Ist-Krümmung 14o vernachlässigbar klein ist. Beide angestrebten Krümmungen 15u, 15o sind im ausgeführten Beispiel spiegelsymmetrisch. Es können beliebige Krümmungen 15u, 15o vorgegeben werden. Die Druckverläufe 16u und 16o zeigen einen Druckabfall im Bereich der aktivierten Fixierelemente 2. Dies zeigt, dass die Fixierung der Substrate 4u, 4o aktiviert ist.

Ein Prozessschritt der Ausrichtung beider Substrate 1u, 1o zueinander wird nicht dargestellt.

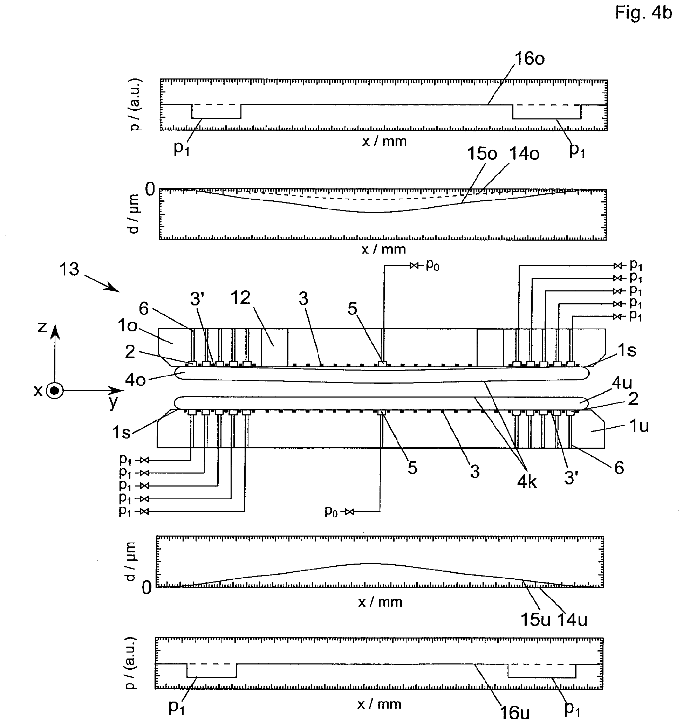

Die Figur 4b zeigt den Bonder 13 bei einem weiteren Prozessschritt. Die beiden Substrate 4u und 4o wurden durch eine Relativbewegung der beiden Substrathalter 1u, 1o aneinander angenähert. Ansonsten hat sich gegenüber der Situation gemäß Figur 4a nichts geändert.

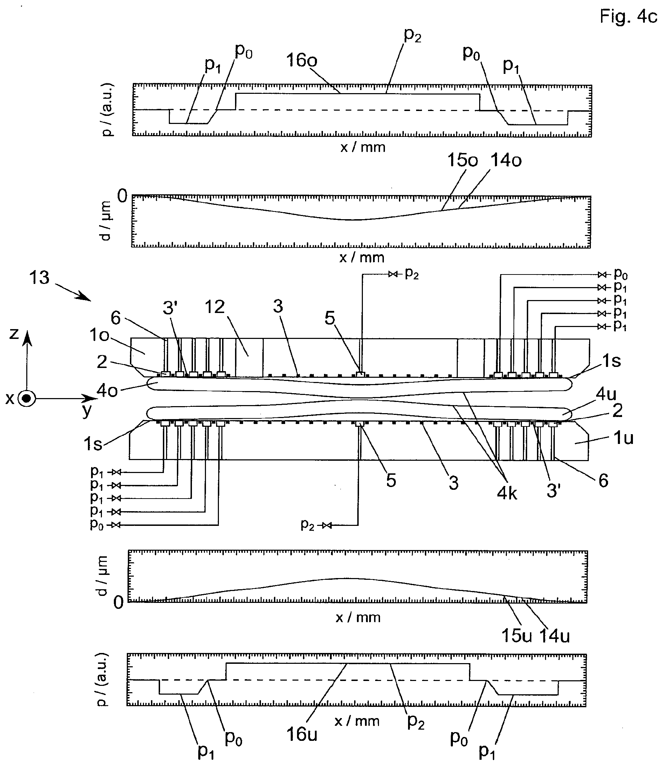

Die Figur 4c zeigt den Bonder 13 bei einem weiteren Prozessschritt. Durch die Verwendung der Krümmungselemente 5, im gezeigten Fall eine Gasaustrittsöffnung, durch die ein Gas mit einem Druck p2 strömt, werden die beiden Substrate 1u, 1o in die Soll-Krümmung gebracht, wobei vorzugsweise eine Regelung des Drucks mittels der Abstandssensoren erfolgt. Für die Steuerung/Regelung können auch die Drücke der Fixierelemente 2 verwendet werden, so dass diese auch Aufgaben der Krümmungsmittel 5, 5' oder Krümmungsänderungsmittel 5, 5' übernehmen und somit im Sinne der Erfindung auch zu diesen zählen können.

Im gezeigten Beispiel wird hierzu eines der Fixierelemente 2 vom Druck p1 auf den Druck p0 zurückgesetzt, um die gewünschte Krümmung vor einer Kontaktierung der Substrate 4o, 4u zu erreichen. In den gezeigten Darstellungen werden, der Einfachheit halber nur drei Druckwerte p0, p1 und p2 gezeigt. Dir Druckwerte sind insbesondere kontinuierlich und/oder stetig steuerbar/regelbar.

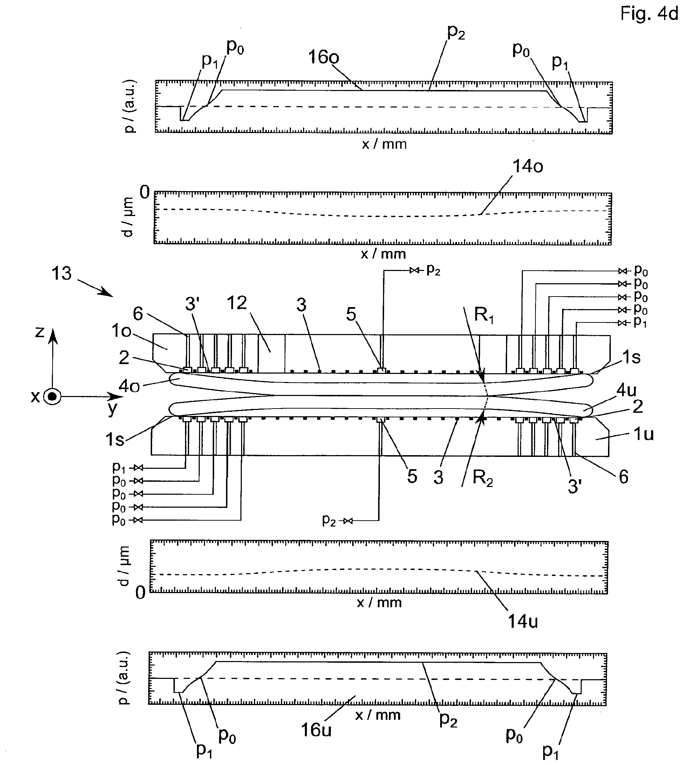

Die Figur 4d zeigt den Bonder 13 bei einem weiteren Prozessschritt. Die beiden Substrate 4u, 4o bilden durch die Annäherung der Substrate 4u, 4o eine Bondwelle, die sich radial nach außen ausbreitet, wobei sich die Krümmung der Substrate 4u, 4o kontinuierlich ändert (Krümmungsänderungsmittel). Dabei wird die Krümmungsänderung des unteren Substrats 1u und des oberen Substrats 1o kontinuierlich mittels der Abstandssensoren überwacht und falls nötig durch das Krümmungselement 5 und/oder die Fixierelemente 2 so korrigiert, dass das die jeweils erwünschte beziehungsweise eingestellte Soll-Krümmung erreicht wird (Krümmungsänderungsmittel). Wichtige Parameter stellen die Krümmungsradien R1 des oberen Substrats 4o und R2 des unteren Substrats 4u im Punkt der Bondwelle dar.

Die Drücke von vier inneren umfänglichen Reihen von Fixierelementen 2 wird bei der oberen Aufnahmeeinrichtung 1o und der unteren Aufnahmeeinrichtung 1u gleichzeitig auf p0 reduziert. Hierdurch verlieren die Substrate 1u, 1o die Fixierung zur Aufnahmefläche 1o, insbesondere kontinuierlich von innen nach außen, wodurch sich der Druck p2 aus dem Krümmungselement 5 weiter ausbreiten kann.

Dadurch, dass die Steuerung die Krümmungen und Krümmungsänderungen der Substrate berücksichtigt, werden run-out-Fehler minimiert.

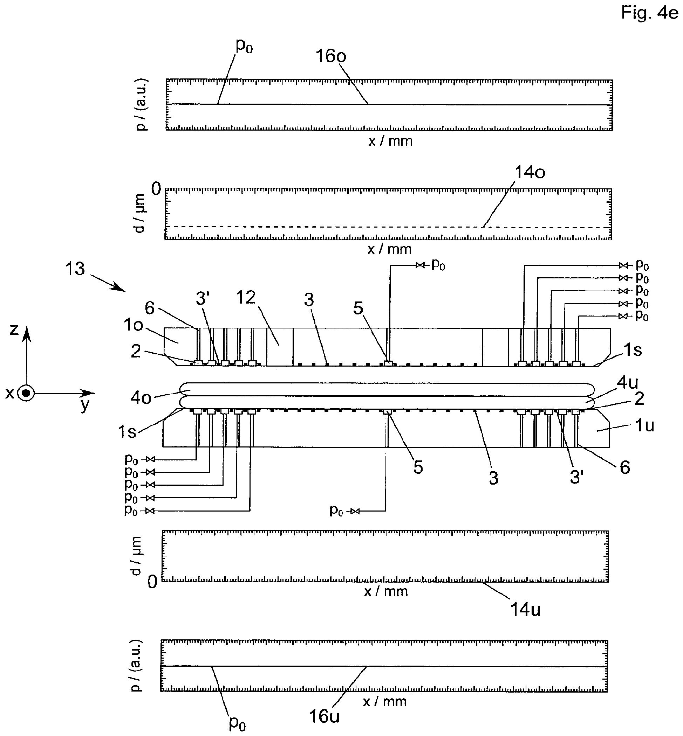

Die Figur 4e zeigt den Bonder 13 bei einem weiteren Prozessschritt. Die beiden Substrate 1u, 1o sind kontrolliert miteinander verbondet worden, indem der Druck der äußersten Reihe der Fixierelemente 2 der oberen Aufnahmeeinrichtung 1o auf p0 reduziert wurde.

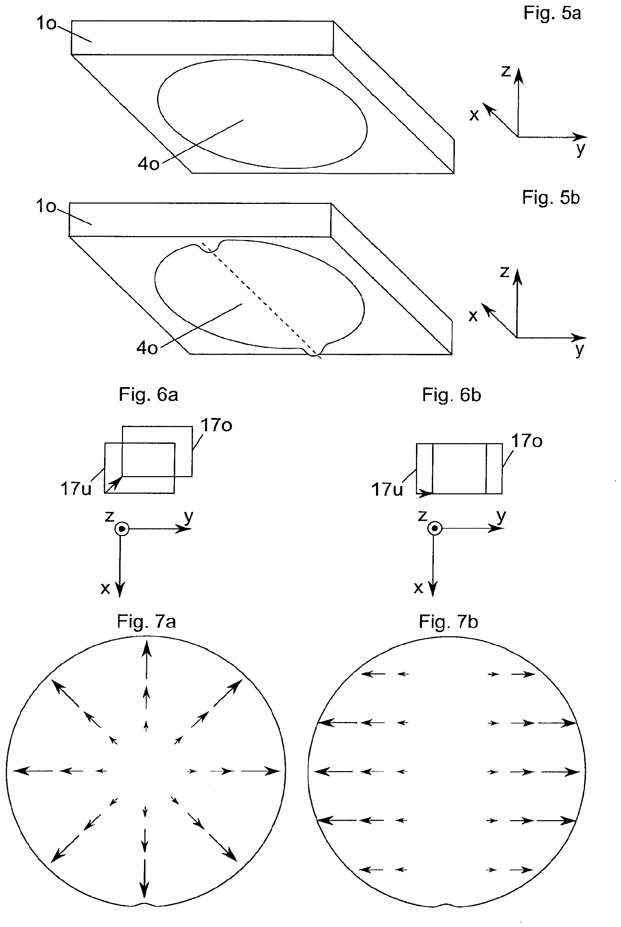

Die Figur 5a zeigt eine Unteransicht eines oberen Probenhalters 1o mit einem fixierten Substrat 4o, welches vollständig fixiert wird. Die X-Achse verläuft in der Aufnahmefläche 1s, 1s', 1s", 1s''' des Substrathalters 1o. Die Y-Achse verläuft senkrecht zur X-Achse und ebenfalls in der Aufnahmefläche 1s, 1s', 1s", 1s''' des Substrathalters 1o. Die Z-Achse verläuft senkrecht zur X- und Y-Achse sowie senkrecht zur Aufnahmefläche 1s, 1s', 1s", 1s'" des Substrathalters 1o.

Die Figur 5b zeigt ebenfalls eine Unteransicht des oberen Probenhalters 1o mit einem teilweise fixierten Substrat 4o, zeitlich gesehen also nach der Darstellung der Fig. 5a. Die Fixiermittel im Zentrum wurden entlang der Kontaktierungsachse X bzw. X-Achse vom Zentrum des Substrats 4o bis zum Außenrand des Substrats 4o deaktiviert, sodass das Substrat 4o entlang der X-Achse durchhängt. Dabei bleiben die übrigen Fixierelemente aktiviert. Die Durchhängung des Substrats 4o wird nicht maßstabsgetreu, insbesondere vergrößert, dargestellt um die Übersichtlichkeit zu erhöhen.

Der "run-out" Fehler, dargestellt durch die Länge eines Pfeils, wird in den Figuren 6a und 6b übertrieben stark eingezeichnet um die Übersichtlichkeit zu erhöhen.

Die Figur 6a zeigt eine obere Struktur 17o einer Substratoberfläche 4k eines oberen Substrats 4o und eine untere Struktur 17u einer Substratoberfläche 4k eines unteren Substrats 4u in der Draufsicht, nachdem die beiden Substrate 4o, 4u mit einem Verfahren aus dem Stand der Technik miteinander verbunden wurden. Deutlich erkennbar ist der, im Allgemeinen multidimensionale "run-out" Fehler, in x- und y-Richtung der durch den Pfeil repräsentiert wird.

Mit besonderem Vorzug kann die uniaxiale Natur der Verzerrungsvektoren bei der Gestaltung der Chipstrukturen am Wafer zunutze gemacht werden. Dabei werden die Strukturen 17u, 17o, z.B. Kontaktpads, so gestaltet, dass sie in jener Richtung, in der die geringeren Verzerrungen auftreten kleiner und / oder mit kleinerem Abstand geplant werden, da hier durch die geringeren Verzerrungen mit einer besseren Überlappung der Pads nach dem Bondvorgang zu rechnen ist. Mit besonderem Vorzug können auch Verzerrungen in jener Richtung, in der die Verzerrungen größer sind, bereits beim Chip Layout mit berücksichtigt werden. Dies ermöglicht eine bessere Überlappung der Strukturen nach dem Bonden auch in dieser Richtung. Durch die überwiegend uniaxiale Natur der Verzerrungen ist dies mit besserer Genauigkeit und geringerem und damit vertretbarem Aufwand möglich im Vergleich zum Stand der Technik.

Die Figur 6b zeigt eine obere Struktur 17o einer Substratoberfläche 4k eines oberen Substrats 4o und eine untere Struktur 17u einer Substratoberfläche 4k eines unteren Substrats 4u in der Draufsicht, nachdem die beiden Substrate 4o, 4u mit dem erfindungsgemäßen Verfahren miteinander verbunden wurden. Deutlich erkennbar ist der, im Allgemeinen eindimensionale "run-out" Fehler, in y-Richtung der durch den Pfeil repräsentiert wird. Die Figur 6b zeigt repräsentativ an, dass der "run-out" Fehler zumindest in x-Richtung gänzlich verschwunden ist. In der Anwendung wird ein, im Allgemeinen viel kleinerer "run-out" Fehler als in Fig. 6a, auch in diesem Fall in x-Richtung existieren. Die Struktur weist immer noch einen, insbesondere sehr kleinen, "run-out" Fehler in y-Richtung auf. Die Überlappung hat sich allerdings auf alle Fälle verbessert. Im Falle einer quadratischen Struktur 17u, 17o kann grob abgeschätzt werden, dass die absolute Länge des Verzerrungsvektors um den Faktor 1,41 sinken wird (Wurzel aus 2). In der Regel sind die Strukturen 17u, 17o häufig rechteckig, d.h. Länge und Breite sind unterschiedlich. Mit Vorteil können dabei die Strukturen 17u, 17o so orientiert werden, dass die Breitseite der Strukturen 17u, 17o parallel zu der Richtung verläuft, für die die größere (insbesondere uniaxiale) Verzerrung erwartet wird. Somit können die, über derartigen Strukturen 17u, 17o zu erwartenden Verzerrungsvektoren minimiert werden. Die Platzierung der Strukturen 17u, 17o am Substrat kann des Weiteren so gestaltet werden, dass die Verzerrung bereits beim Layout berücksichtigt wird. Mit Vorteil wird dabei die Platzierung der Strukturen 17u, 17o so designed, dass der, aus der Verzerrung resultierende Überlappungsfehler an der Mittelposition der Breitseite der Strukturen 17u, 17o verschwindet und auf der einen Seite der Mitte der Verzerrungsfehlervektor ein positives Vorzeichen hat und auf der anderen Seite ein negatives Vorzeichen hat.

Die Figur 7a zeigt eine Vektorfeldkarte eines Substratstapels aus Substraten 4o, 4u dessen Vektoren den "run-out" Fehler repräsentieren. Erkennbar ist eine radialsymmetrische Symmetrie, mit größer werdendem "run-out" Fehler vom Zentrum zum Rand.

Die Figur 7b zeigt eine Vektorfeldkarte eines Substratstapels aus Substraten 4o, 4u dessen Vektoren den "run-out" Fehler repräsentieren. Erkennbar ist eine uniaxiale Symmetrie, mit größer werdendem "run-out" Fehler vom Zentrum zum Rand. Durch das erfindungsgemäße Verfahren der uniaxialen Biegung der Substrate, kann der "run-out" Fehler zumindest entlang der x-Achse vernachlässigbar klein gemacht werden. Im Idealfall wird sogar der "run-out" Fehler entlang der y-Achse vernachlässigbar klein. Auf eine Darstellung eines Substratstapels mit verschwindend geringem "run-out" Fehler in alle Richtung in einer weiteren Figur wurde allerdings verzichtet, da man aus einer solchen Figur keine neuen Erkenntnisse gewinnen kann.

### Bezugszeichenliste

- 1, 1', 1", 1"',: Aufnahmeeinrichtung/Substrathalter
- 1^{IV}, 1^{V}, 1^{VI}, 1^{VII}: Aufnahmeeinrichtung/Substrathalter
- 1o: erste Aufnahmeeinrichtung/ oberer Substrathalter
- 1u: zweite Aufnahmeeinrichtung/unterer Substrathalter
- 1s, 1s', 1s", 1s'": Aufnahmefläche
- 2, 2', 2", 2'": Fixierelemente
- 2o''': Fixierelementoberfläche
- 3, 3': Sensoren
- 4o: erstes/oberes Substrat
- 4u: zweites/unteres Substrat
- 4a: Substrataufnahmefläche
- 5, 5': Verformelement/Krümmungselement
- 6: Leitung
- 7, 7⁴, 7", 7''', 7'''': Erhebungen/Noppen
- 7o: Noppenoberfläche
- 8: Steg
- 9: Raumbereich
- 10: Randelement
- 11: Noppenebene
- 12: Vermessungslöcher
- 13: Bonder
- 14u, 14o: Ist-Krümmung
- 15u, 15o: Soll-Krümmung
- 16u, 16o: Druckverlauf
- 17u, 17o: Strukturen
- L, L': Linie
- x: Position
- d: Abstand
- p: Druck
- R1, R2: Krümmungsradius
- X: Kontaktierungsachse
- Y, Z: Achse
- Z1-Z6: Zone

## Patentansprüche

1. Verfahren zum Bonden eines ersten Substrats (40) mit einem zweiten Substrat (4u) an einander zugewandten Kontaktflächen (4k) der Substrate (4o, 4u) mit folgenden Schritten, insbesondere folgendem Ablauf:
Aufnahme des ersten Substrats (40) an einer ersten Aufnahmefläche (1s, 1s', 1s", 1s"') einer ersten Aufnahmeeinrichtung (1, 1', 1", 1''', 1^{IV}, 1^{V} 1^{VI}, 1^{VII}) und Aufnahme des zweiten Substrats (4u) an einer zweiten Aufnahmefläche (1s, 1s', 1s", 1s''') einer zweiten Aufnahmeeinrichtung (1, 1', 1", 1''', 1^{IV}, I^{V}, 1^{VI}, 1^{VII})
Befestigung der Substrate (4o, 4u) an den Aufnahmeflächen (1s, 1s', 1s", 1s"') durch Fixierelemente (2, 2', 2", 2'''),
- Krümmung mindestens einer der Kontaktflächen (4k) vor einer Kontaktierung der Kontaktflächen (4k),
**dadurch gekennzeichnet, dass**
nach der Kontaktierung zunächst nur diejenigen Fixierelemente (2, 2', 2", 2''') abgeschaltet werden, die uniaxial entlang einer einzigen Kontaktierungsachse (X) angeordnet sind, und die übrigen Fixierelemente (2, 2', 2", 2''') eingeschaltet bleiben, sodass die Substrate (4o, 4u) zunächst lediglich uniaxial entlang der Kontaktierungsachse (X) miteinander verbunden werden,
wobei danach die übrigen Fixierelemente (2, 2', 2", 2''') abgeschaltet werden, sodass die Substrate (4o,4u) vollflächig miteinander verbunden werden.

2. Verfahren nach Anspruch 1, wobei die Fixierelemente (2, 2', 2", 2''') rasterförmig angeordnet sind, wobei bevorzugt die Abstände benachbarter Fixierelemente (2, 2', 2", 2''') konstant sind.

3. Verfahren nach einem der vorhergehenden Ansprüche, wobei die Fixierelemente (2, 2', 2", 2''') sequentiell abgeschaltet werden, bevorzugt von innen nach außen und/oder mit gleichem Zeitabstand.

4. Verfahren nach einem der vorhergehenden Ansprüche, wobei die Fixierelemente (2, 2', 2", 2''') entlang einer Kurve, insbesondere einer Geraden, gleichzeitig abgeschaltet werden.

5. Verfahren nach einem der vorhergehenden Ansprüche, wobei die Krümmung durch ein länglich entlang der Kontaktierungsachse (X) ausgebildetes Verformelement (5, 5') und/oder mehrere entlang der Kontaktierungsachse (X) angeordnete Verformelemente (5, 5') erzeugt wird.

6. Verfahren nach einem der vorhergehenden Ansprüche, wobei die Krümmung konvex erfolgt aus Sicht des gegenüberliegenden Substrats (4o, 4u).

7. Verfahren nach einem der vorhergehenden Ansprüche, wobei die Krümmungen der beiden Substrate spiegelbildlich zueinander erfolgen.

8. Verfahren nach einem der vorhergehenden Ansprüche, wobei die Kontaktierungsachse (X) durch das Zentrum eines der Substrate (4o, 4u) verläuft, bevorzugt durch die Zentren beider Substrate (4o, 4u).

9. Verfahren nach einem der vorhergehenden Ansprüche, wobei die Kontaktierung der Substrate (4o, 4u) in den Zentren der Substrate (4o, 4u) initiiert wird, wobei bevorzugt die Kontaktierung der Substrate (4o, 4u) entlang der Kontaktierungsachse (X) vollständig bis zu den Außenrändern der Substrate (4o, 4u) erfolgt.

10. Verfahren nach einem der vorhergehenden Ansprüche, wobei die Fixierung der Substrate (4o, 4u) ausschließlich an deren Außenrändern erfolgt.

11. Verfahren nach einem der vorhergehenden Ansprüche, wobei die Fixierelemente (2, 2', 2", 2''') in mehreren Zonen (Z1,Z2,Z3,Z4,Z5,Z6) zusammengefasst sind, wobei die Zonen (Z1,Z2,Z3,Z4,Z5,Z6) separat ein- und ausschaltbar sind und/oder an den Außenrändern der Substrate (4o, 4u) angeordnet sind, wobei die Zonen (Z1,Z2,Z3,Z4,Z5,Z6) bevorzugt in gleichmäßigem Abstand zueinander verteilt an den Außenrändern der Substrate (4o, 4u) angeordnet sind.

12. Vorrichtung zum Bonden eines ersten Substrats (40) mit einem zweiten Substrat (4u) an einander zugewandten Kontaktflächen (4k) der Substrate (4o, 4u) mit:
einer ersten Aufnahmeeinrichtung (1, 1', 1", 1''', 1^{IV}, 1^{V}, 1^{VI},1^{VII}) zur Aufnahme des ersten Substrats (40) an einer ersten Aufnahmefläche (1s, 1s', 1s", 1s"') und einer zweiten Aufnahmeeinrichtung (1, 1', 1'', 1''', 1^{IV}, 1^{V}, 1^{VI}, 1^{VII}) zur Aufnahme des zweiten Substrats (4u) an einer zweiten Aufnahmefläche (1s, 1s', 1s", 1s'''),
- Krümmungsmitteln zur Krümmung mindestens einer der Kontaktflächen (4k) vor einer Kontaktierung der Kontaktflächen (4k),
**dadurch gekennzeichnet, dass**
die Vorrichtung Steuermittel aufweist, sodass nach der Kontaktierung zunächst nur diejenigen Fixierelemente (2, 2', 2", 2''') abschaltbar sind, die uniaxial entlang einer einzigen Kontaktierungsachse (X) angeordnet sind, und die übrigen Fixierelemente (2, 2', 2", 2''') eingeschaltet bleiben können, sodass die Substrate (4o, 4u) zunächst lediglich uniaxial entlang der Kontaktierungsachse (X) miteinander verbindbar sind,
wobei danach die übrigen Fixierelemente (2, 2', 2", 2''') abschaltbar sind, sodass die Substrate (4o,4u) vollflächig miteinander verbindbar sind.

## Claims

1. A method for bonding a first substrate (40) with a second substrate (4u) at mutually facing contact faces (4k) of the substrates (4o, 4u) with the following steps, in particular the following sequence:
- holding of the first substrate (40) to a first holding surface (1s, 1s', 1s", 1s''') of a first holding device (1, 1' 1", 1''', 1^{IV}, 1^{V}, 1^{VI}, 1^{VII}) and holding of the second substrate (4u) to a second holding surface (1s, 1s', 1s", 1s''') of a second holding (1, 1' 1", 1''', 1^{IV}, 1^{V}, 1^{VI}, 1^{VII})
- fixing of the substrates (4o, 4u) to the holding surfaces (1s, 1s', 1s", 1s''') by means of fixing elements (2, 2', 2", 2'''),
- curvature of at least one of the contact faces (4k) before contacting of the contact faces (4k),
**characterised in that**,
after the contacting, only those fixing elements (2, 2', 2", 2''') are first switched off which are arranged uniaxially along a single contacting axis (X), and the remaining fixing elements (2, 2', 2", 2''') remain switched on, so that the substrates (4o, 4u) are first joined together only uniaxially along the contacting axis (X), wherein the remaining fixing elements (2, 2', 2", 2''') are thereafter switched off, so that the substrates (4o, 4u) are joined together over the whole area.

2. The method according to claim 1, wherein the fixing elements (2, 2', 2", 2''') are arranged in a grid shape, wherein the distances between adjacent fixing elements (2, 2' , 2", 2''') are preferably constant.

3. The method according to any one of the preceding claims, wherein the fixing elements (2, 2', 2", 2''') are switched off sequentially, preferably from the inside outwards and/or with the same time interval.

4. The method according to any one of the preceding claims, wherein the fixing elements (2, 2', 2", 2''') are switched off simultaneously along a curve, in particular a straight line.

5. The method according to any one of the preceding claims, wherein the curvature is generated by a deformation element (5, 5') constituted in an elongated manner along the contacting axis (X) and/or a plurality of deformation elements (5, 5') arranged along the contacting axis (X).

6. The method according to any one of the preceding claims, wherein the curvature takes place in a convex manner as viewed from the opposite substrate (4o, 4u).

7. The method according to any one of the preceding claims, wherein the curvatures of both substrates take place mirror-inverted with respect to one another.

8. The method according to any one of the preceding claims, wherein the contacting axis (X) runs through the centre of one of the substrates (4o, 4u), preferably through the centres of both substrates (4o, 4u).

9. The method according to any one of the preceding claims, wherein the contacting of the substrates (4o, 4u) is initiated in the centres of the substrates (4o, 4u), wherein the contacting of the substrates (4o, 4u) preferably takes place along the contacting axis (X) completely up to the outer edges of the substrates (4o, 4u).

10. The method according to any one of the preceding claims, wherein the fixing of the substrates (4o, 4u) takes place solely at their outer edges.

11. The method according to any one of the preceding claims, wherein the fixing elements (2, 2', 2", 2''') are grouped into a plurality of zones (Z1,Z2,Z3,Z4,Z5,Z6), wherein the zones (Z1,Z2,Z3,Z4,Z5,Z6) can be switched on and off separately and/or are arranged at the outer edges of the substrates (4o, 4u), wherein the zones (Z1,Z2,Z3,Z4,Z5,Z6) are preferably arranged at the outer edges of the substrates (4o, 4u) distributed with a uniform spacing from one another.

12. A device for bonding a first substrate (40) with a second substrate (4u) at mutually facing contact faces (4k) of the substrates (4o, 4u) with:
a first holding device (1, 1' ,1", 1''', 1^{IV} , 1^{V}, 1^{VI}, 1^{VII}) for holding the first substrate (40) to a first holding surface (1s, 1s', 1s", 1s''') and a second holding device (1, 1' 1", 1''', 1^{IV}, 1^{V}, 1^{VI}, 1^{VII}) for holding the second substrate (4u) to a second holding surface (1s, 1s', 1s", 1s''')
- curvature means for the curvature of at least one of the contact faces (4k) before contacting of the contact faces (4k),
**characterised in that**
the device comprises control means, so that after the contacting only those fixing elements (2, 2', 2", 2'") can first be switched off which are arranged uniaxially along a single contacting axis (X), and the remaining fixing elements (2, 2', 2", 2'") can remain switched on, so that the substrates (4o, 4u) can first be joined together only uniaxially along the contacting axis (X),
wherein the remaining fixing elements (2, 2', 2", 2'") can thereafter be switched off, so that the substrates (4o, 4u) can be joined together over the whole area.

## Revendications

1. Procédé destiné à la liaison d'un, premier substrat (40) à un second subtrat (4u) sur des surfaces de contact (4k) orientées l'une vers l'autre des substrats (4o, 4u) comprenant les étapes suivantes, en particulier le déroulement suivant :
- réception du premier substrat (40) sur une première surface de réception (1s, 1s', 1s", 1s''') d'un premier dispositif de réception (1, 1', 1", 1''', 1^{IV}, 1^{V}, 1^{VI}, 1^{VII}) et réception du second substrat (4u) sur une seconde surface de réception (1s, 1s', 1s", 1s''') d'un second dispositif de réception (1, 1', 1", 1''',1^{IV}, 1^{V}, 1^{VI}, 1^{VII})
- fixation des substrats (4o, 4u) sur les surfaces de réception (1s, 1s', 1s", 1s''') par des éléments de fixation (2, 2', 2", 2'''),
- courbure d'au moins une des surfaces de contact (4k) avant une mise en contact des surfaces de contact (4k),
**caractérisé en ce**
**qu'**après la mise en contact, seuls les éléments de fixation (2, 2', 2", 2'") qui sont disposés de façon uniaxiale le long d'un seul axe de mise en contact (X) sont d'abord déconnectés, et les éléments de fixation (2, 2', 2", 2'") restants restent connectés, de sorte que les substrats (4o, 4u) sont reliés entre eux d'abord uniquement de façon uniaxiale le long de l'axe de mise en contact (X),
dans lequel ensuite, les éléments de fixation (2, 2', 2", 2'") restants sont déconnectés, de sorte que les substrats (4o, 4u) sont reliés entre eux sur toute leur surface.

2. Procédé selon la revendication 1, dans lequel les éléments de fixation (2, 2', 2", 2''') sont disposés en formant une grille, dans lequel de préférence les distances entre des éléments de fixation (2, 2', 2", 2''') voisins sont constantes.

3. Procédé selon l'une des revendications précédentes, dans lequel les éléments de fixation (2, 2', 2", 2''') sont déconnectés de manière séquentielle, de préférence de l'intérieur vers l'extérieur et/ou à égale distance temporelle.

4. Procédé selon l'une des revendications précédentes, dans lequel les éléments de fixation (2, 2', 2", 2''') sont déconnectés en même temps, le long d'une courbe, en particulier d'une droite.

5. Procédé selon l'une des revendications précédentes, dans lequel la courbure est produite par un élément de déformation (5, 5') formé longitudinalement le long de l'axe de mise en contact (X) et/ou plusieurs éléments de déformation (5, 5') disposés le long de l'axe de mise en contact (X).

6. Procédé selon l'une des revendications précédentes, dans lequel la courbure est convexe vue du substrat (4o, 4u) opposé.

7. Procédé selon l'une des revendications précédentes, dans lequel les courbures des deux substrats sont formées en miroir l'une par rapport à l'autre.

8. Procédé selon l'une des revendications précédentes, dans lequel l'axe de mise en contact (X) passe à travers le centre d'un des substrats (4o, 4u), de préférence à travers les centres des deux substrats (4o, 4u).

9. Procédé selon l'une des revendications précédentes, dans lequel la mise en contact des substrats (4o, 4u) est initiée dans les centres des substrats (4o, 4u), dans lequel la mise en contact des substrats (4o, 4u) est effectuée de préférence le long de l'axe de mise en contact (X) et complètement jusqu'aux bords extérieurs des substrats (4o, 4u).

10. Procédé selon l'une des revendications précédentes, dans lequel la fixation des substrats (4o, 4u) est effectuée exclusivement sur leurs bords extérieurs.

11. Procédé selon l'une des revendications précédentes, dans lequel les éléments de fixation (2, 2', 2", 2''') sont regroupés dans plusieurs zones (Z1, Z2, Z3, Z4, Z5, Z6), dans lequel les zones (Z1, Z2, Z3, Z4, Z5, Z6) peuvent être connectées et déconnectées séparément et/ou sont disposées sur les bords extérieurs des substrats (4o, 4u), dans lequel les zones (Z1, Z2, Z3, Z4, Z5, Z6) sont disposées de préférence réparties entre elles à distance égale sur les bords extérieurs des substrats (4o, 4u).

12. Dispositif destiné à la liaison d'un premier substrat (4o) à un second substrat (4u) sur des surfaces de contact (4k) orientées l'une vers l'autre des substrats (40, 4u) comprenant :
- un premier dispositif de réception (1, 1', 1", 1''', 1^{IV}, 1^{V}, 1^{VI}, 1^{VII}) pour recevoir le premier substrat (40) sur une première surface de réception (1s, 1s', 1s", 1s''') et un second dispositif de réception (1,1', 1", 1''', 1^{IV}, 1^{V}, 1^{VI}, 1^{VII}), pour recevoir le second substrat (4u) sur une seconde surface de réception (1s, 1s', 1s", 1s'''),
- des moyens de courbure pour courber au moins une des surfaces de contact (4k) avant une mise en contact des surfaces de contact (4k),
**caractérisé en ce que**
le dispositif présente des moyens de commande, de sorte qu'après la mise en contact, seuls les éléments de fixation (2, 2', 2", 2'") qui sont disposés de façon uniaxiale le long d'un seul axe de mise en contact (X) peuvent être d'abord déconnectés, et les éléments de fixation (2, 2', 2", 2''') restants restent connectés, de sorte que les substrats (4o, 4u) peuvent être reliés entre eux d'abord uniquement de façon uniaxiale le long de l'axe de mise en contact (X),
dans lequel ensuite, les éléments de fixation (2, 2', 2", 2''') restants peuvent être déconnectés, de sorte que les substrats (4o, 4u) peuvent être reliés entre eux sur toute leur surface.
